(19) Europäisches Patentamt
European Patent Office
Office européen des brevets

(11) **EP 1 926 216 A1**

(12) **EUROPEAN PATENT APPLICATION**

(43) Date of publication:
**28.05.2008 Bulletin 2008/22**

(51) Int Cl.:
***H03M 13/27*** *(2006.01)*    ***H03M 13/29*** *(2006.01)*

(21) Application number: **06024549.5**

(22) Date of filing: **27.11.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicant: **NTT DoCoMo, Inc.**
**Chiyoda-ku**
**Tokyo 100-6150 (JP)**

(72) Inventor: **Bauch, Gerhard**
**80799 Munich (DE)**

(74) Representative: **Zinkler, Franz et al**
**Patentanwälte Schoppe, Zimmermann,**
**Stöckeler & Zinkler,**
**Postfach 246**
**82043 Pullach bei München (DE)**

Remarks:
Amended claims in accordance with Rule 137(2) EPC.

(54) **Interleaver design for parallel concatenated zigzag codes**

(57)    An Encoder (100) for generating an output codeword based on an input information word, the input information word having fewer bits than the output codeword. The encoder (100) comprises a segmenter (110) for segmenting the input information word into a plurality of ordered segments, the segments having bits. The encoder (100) further comprises a zigzag encoder (120) for calculating a redundancy bit for a current segment, wherein a redundancy bit of an earlier segment in the order is used when calculating the redundancy bit for the current segment. The encoder (100) comprises an interleaver (130) for interleaving the bits of the plurality of segments using an interleaving rule to obtain an interleaved version and an output codeword constructor (140) for constructing the output codeword using an input codeword or the interleaved version thereof and a set of redundancy bits generated by the zigzag encoder (120) fed by the interleaved version. Furthermore, the interleaver (130) is adapted to use the interleaving rule, being such that at least 50% of all the segments of the input information word bits of the input information word within the same segment are relocated to at least one different segment of the interleaved version.

## FIG 1

**Description**

The present invention relates to the field of communication networks, as for example WCDMA (Wideband Code Division Multiple Access) and OFDMA (Orthogonal Frequency Division Multiple Access) based networks as specified by the international standardization bodies, where zigzag codes and concatenated zigzag codes are under consideration for enhancements of present communication systems, like UMTS, and candidates for introduction in future communication systems as LTE for error control coding.

Concatenated zigzag codes are attractive coding schemes since they offer excellent performance while having relatively low encoding and decoding complexity. Powerful codes are obtained by parallel concatenation of several constituent zigzag codes, which encode interleaved versions of the data sequence. This implies a new problem in interleaver design: Not only one interleaver, which is optimized for iterative decoding is needed, but several interleavers are needed. Each of those interleavers should provide good performance of iterative decoding while the interleavers should be mutually as independent as possible.

Zigzag codes have been proposed in L. Ping, X. Huang, and N. Phamdo, "Zigzag codes and concatenated zigzag codes," IEEE Transactions on Information Theory, vol. 47, pp. 800-807, February 2001, and extended in S.-N. Hong and D.-J. Shin, "Construction and analysis of rate compatible punctured concatenated zigzag codes," in International Symposium on Information Theory (ISIT), pp. 840-844, IEEE, September 2005, S.-N. Hong and D.-J. Shin, "Optimal rate-compatible punctured concatenated zigzag codes," in International Conference on Communications (ICC), pp. 627-631, IEEE, May 2005, S.-N. Hong and D.-J. Shin, "Design of irregular concatenated zigzag codes," in International Symposium on Information Theory (ISIT), pp. 1363-1366, IEEE, September 2005, L. Ping, S. Chan, and K. Yeung, "Iterative decoding of multidimensional concatenated single parity check codes," in International Conference on Communications (ICC), pp. 131-135, IEEE, June 1998, X. Wu, Y. Xue, and H. Xiang, "On concatenated zigzag codes and their decoding schemes," IEEE Communications Letters, vol. 8, pp. 54-56, January 2004, N. Nefedov, "Multi-dimensional zigzag codes for high data rate transmission," in 3rd International Symposium on Turbo Codes and Related Topics, pp. 215-218, September 2003, N. Nefedov, data rate transmission," in 14th International Symposium on Personal, Indoor and Mobile Radio Communications, pp. 1868-1872, September 2003.

They are attractive because of their low encoding and decoding complexity and their excellent performance particularly with high code rates. Concatenated zigzag codes with iterative decoding perform only about 0.5 dB worse than parallel-concatenated convolutional codes (turbo codes) while having significantly lower complexity. A single zigzag code is a very weak code due to its small minimum Hamming distance of $d_{min}$ = 2. Strong codes are obtained by concatenation of zigzag codes where each constituent code encodes an interleaved version of the data sequence. Since a zigzag code has usually relatively high rate, multiple zigzag codes have to be concatenated in order to obtain codes with reasonable rate and error correction capabilities. Building low rate codes by concatenation of several constituent codes is a difference to turbo codes, where usually only two constituent codes are concatenated.

This implies a new problem in interleaver design: Not only one interleaver, which is optimized for iterative decoding is needed but several interleavers are needed. Each of those interleavers should provide good performance of iterative decoding while the interleavers should be mutually as independent as possible. It is still an open problem what is a good criterion for mutual independency of multiple interleavers. At the same time, the interleavers shall introduce randomness such that the extrinsic information of the constituent decoders becomes approximately uncorrelated.

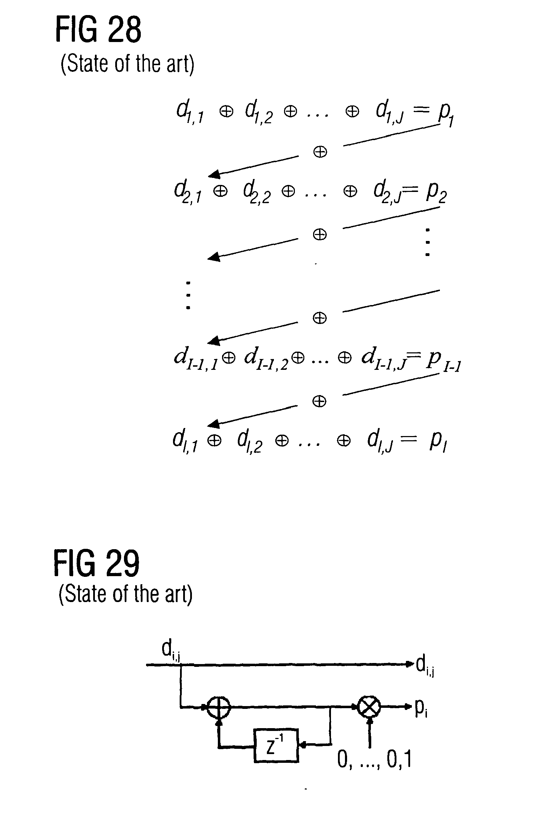

Zigzag codes are attractive because of their low encoding and decoding complexity and their excellent performance particularly with high code rate. Concatenated zigzag codes perform only about 0.5 dB worse than parallel-concatenated convolutional codes (turbo codes) while having significantly lower complexity. The principle of regular zigzag codes is illustrated in Fig. 28, where $\oplus$ denotes the modulo 2 sum. The data bits $d_{i,j} \in \{0, 1\}$ are arranged in an $I \times J$ matrix. Each row of the matrix is called a segment of the zigzag code. The parity bits $p_i$ are determined as the modulo 2 sum over each segment $i$ including the previous parity bit $p_{i-1}$. The zigzag code is completely described by the two parameters $I$ and $J$.

An equivalent encoder for a zigzag code is a punctured recursive convolutional encoder with memory 1 as depicted in Fig. 29. The puncturing pattern for the parity bits is chosen such that only every $J$-th parity bit of the trellis encoder is transmitted. A single zigzag code has weak performance since the minimum Hamming distance is $d_{min}$ = 2. This is easily verified when two data bits within a segment $i$ are flipped.

In this case, the parity bit $p_i$ will remain unchanged and consequently no other bits in the codeword are affected. A codeword with minimum Hamming weight $w_H = d_{min} = 2$ occurs, if the data sequence contains only two bits with value $d_{i,j}$ = 1 which are located within the same segment as depicted in Fig. 30. Low weight codewords with Hamming weight $w_H$=3 are generated if a single bit with value 1 appears in two consecutive segments as shown in Fig. 31. In order to build a powerful code, several constituent zigzag codes have to be concatenated. Each of the respective constituent encoders encodes an interleaved sequence of the data bits as shown in Fig. 32, where $\Pi_k$ indicates the permutation rule of interleaver $k$. Since the code rate $R_c = J/(J+1)$ of a zigzag code is usually relatively high, several zigzag codes need to be concatenated.

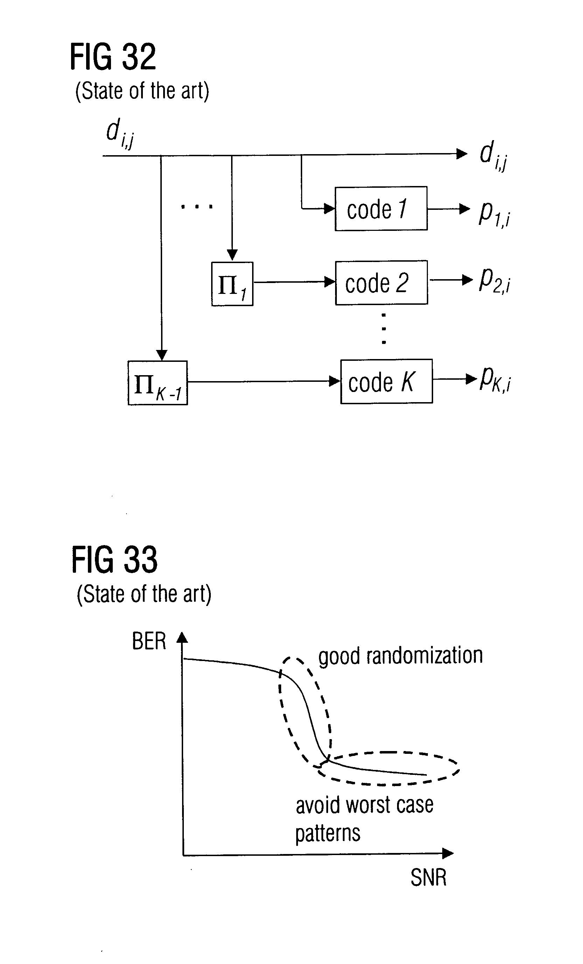

Fig. 33 schematically illustrates the performance in terms of bit error ratio over signal-to-noise-ratio. Typical interleaver design criteria for iterative decoding approaches can be derived from the view graph shown in Fig. 33. A good performance with iterative decoding can be obtained if good randomization is carried out by the interleaving rule, which is indicated in the view graph. A good randomization supports a steep slope of the bit error rate view graph. Another design criterion is the avoidance of the worst case patterns, as they cause a rather gentle slope of the bit error rate view graph and an error floor, as also indicated in Fig. 33.

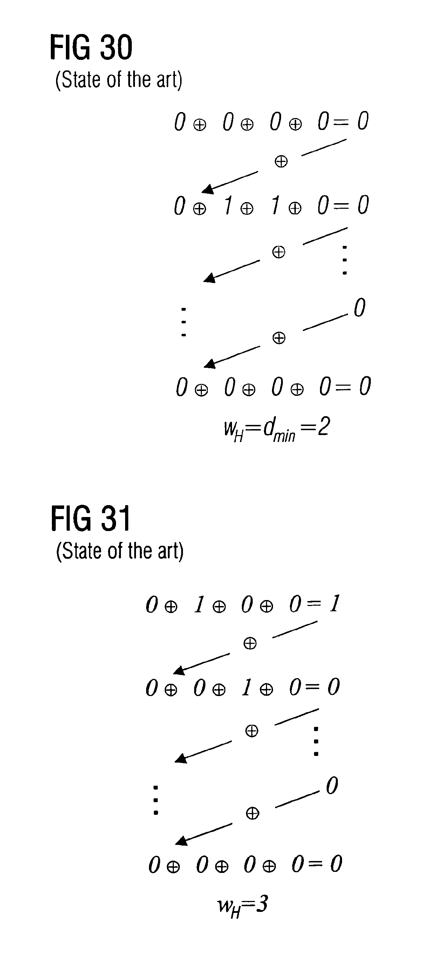

For the concatenated constituent codes, only the parity bits are transmitted. With K constituent codes, the overall code rate becomes $R_C = J/(J + K)$. The use of multiple interleavers is an essential difference to turbo codes, where usually only two constituent codes are concatenated. This implies a new problem in interleaver design: Not only one interleaver, which is optimized for iterative decoding is needed but several interleavers are needed. Each of those interleavers should provide good performance of iterative decoding while the interleavers should be mutually as independent as possible. It is still an open problem what is a good criterion for mutual independency of multiple interleavers. One intuitive condition might be that, in order to increase the minimum Hamming distance of the overall code, the interleaving should make sure that bits which are within one segment at the input of a certain constituent encoder are not mapped to the same segment or adjacent segments at the input of any other constituent encoder. The problem is illustrated for an example in Fig. 30. Codewords with minimum Hamming weight $w_H = d_{min} = 2$ at the output of a zigzag constituent code are generated by data sequences, where two bits of value $d_{i,j} = 1$ are located within the same segment $i$. In order to increase the minimum Hamming distance of the overall code, the interleaver should make sure that those data sequences produce a codeword with higher Hamming weight at the output of the other constituent encoders. Therefore, the two 1-valued bits should be spread as far as possible as demonstrated on the right hand side of Fig. 30.

The representation in Fig. 29 suggests that a zigzag code can be decoded by a trellis based algorithm such as the BCJR algorithm in L. Bahl, J. Cocke, F. Jelinek, and J. Raviv, "Optimal decoding of linear codes for minimizing symbol error rate," IEEE Transactions on Information Theory, vol. IT-20, pp. 284-287, March 1974. At the decoder input, zeros have to be inserted at the positions of the punctured bits and for initialization of the backward recursion, all end states of the trellis may be assumed to be equally likely since the zigzag encoder is not terminated in a predetermined state. However, the division in segments allows the decoding of zigzag codes using a significantly less complex algorithm called the MLA algorithm which also executes a forward and a backward recursion. The simple version of the MLA algorithm as described in L. Ping, X. Huang, and N. Phamdo, "Zigzag codes and concatenated zigzag codes," IEEE Transactions on Information Theory, vol. 47, pp. 800-807, February 2001, works only for AWGN channels with constant SNR over a codeword. Here a more general description based on log-likelihood ratios that also works in time-varying channels and for higher order modulation is given. The noisy received values are denoted after demapping from the modulated symbols for data and parity bits, respectively, by $d_{i,j}$ and $p_i$, respectively. First, the channel information log-likelihood ratios are computed

$$L_c(d_{i,j}) = \log \frac{p(d_{i,j} = 0 | \widetilde{d}_{i,j})}{p(d_{i,j} = 1 | \widetilde{d}_{i,j})}, \tag{1}$$

$$L_c(p_i) = \log \frac{p(p_i = 0 | \widetilde{p}_i)}{p(p_i = 1 | \widetilde{p}_i)} \tag{2}$$

of the received codebits based on the channel statistics and the transmit symbol alphabet. Next, the possibly available a-priori information is taken

$$L_a(d_{i,j}) = \log \frac{P_a(d_{i,j} = 0)}{P_a(d_{i,j} = 1)} \tag{3}$$

on the data bits into consideration by adding it to the channel information

$$L_{c\&a}(d_{i,j}) = L_c(d_{i,j}) + L_a(d_{i,j}). \qquad (4)$$

Now, a forward metric for the parity bits can be computed according to

$$F(p_1) = L_{c\&a}(p_1) + \sum_{\substack{j=1 \\ [+]}}^{J} L_{c\&a}(d_{1,j}) \qquad (5)$$

$$F(p_i) = \underbrace{L_{c\&a}(p_i)}_{channel\&a-priori\,info} + \underbrace{\left( F(p_{i-1})[+]\sum_{\substack{j=1 \\ [+]}}^{J} L_{c\&a}(d_{i,j}) \right)}_{\substack{extrinsic\,info \\ i=2,...,J,}} \qquad (6)$$

where $\sum_{\substack{j=1 \\ [+]}}^{J} a_j = a_1[+]a_2[+]..[+]a_j$ denotes the boxplus sum. The boxplus sum is the operation with log-likelihood ratios which corresponds to the modulo 2 sum of the respective bits as shown by J. Hagenauer, E. Offer, and L. Papke, "Iterative decoding of binary block and convolutional codes," IEEE Transactions on Information Theory, vol. IT-42, pp. 425-429, March 1996, i.e.

$$L(a_1 \oplus a_2) = L(a_1)[+]L(a_2). \qquad (7)$$

The exact expression for the boxplus sum is given by J. Hagenauer, E. Offer, and L. Papke, "Iterative decoding of binary block and convolutional codes," IEEE Transactions on Information Theory, vol. IT-42, pp. 425-429, March 1996.

$$L(a_1)[+]L(a_2) = \log \frac{1 + e^{L(a_1)}e^{L(a_2)}}{e^{L(a_1)} + e^{L(a_2)}} \qquad (8)$$

It can be approximated by

$$L(a_1)[+]L(a_2) \approx sign\{L(a_1)\}\, sign\{L(a_2)\} \min\{|L(a_1)|, |L(a_2)|\} \qquad (9)$$

The first term in (6) is the direct channel info on the parity bit $p_i$ plus a-priori info, the second term is extrinsic information, i.e. the information about $p_i$ which can be obtained from all the previous bits in the codeword due to the code constraints. Similarly, a backward recursion can be computed

$$B(p_i) = \underbrace{L_{c\&a}(p_i)}_{\text{channel\&a-priori info}} + \underbrace{\left( P(p_{i+1})[+]\sum_{\substack{j=1 \\ [+]}}^{J} L_{c\&a}(d_{i+1,j}) \right)}_{\substack{\text{extrinsic info} \\ i=0,\ldots,J-1.}} \qquad (10)$$

The APP log-likelihood ratios are then obtained from

$$L_{app}(d_{1,j}) = L_{c\&a}(d_{1,j})[+]B(p_1)[+] \sum_{\substack{l=1, l\neq j \\ [+]}}^{J} L_{c\&a}(d_{1,l})$$

$$L_{app}(d_{i,j}) = \underbrace{L_{c\&a}(d_{i,j})}_{\text{channel \& a-priori info}} \qquad (11)$$

$$+ \underbrace{F(p_{i-1})[+]B(p_i)[+] \sum_{\substack{l=1, l\neq j \\ [+]}}^{J} L_{c\&a}(d_{i,j})}_{\text{extrinsic info}} \qquad (12)$$

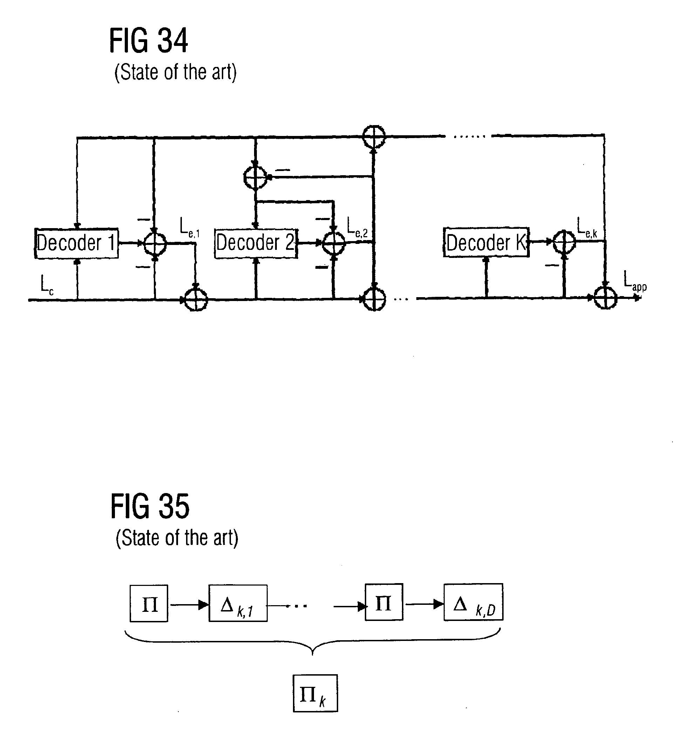

The first term in (12) is the direct channel info on the bit $d_{i,j}$ plus a-priori info, the other terms constitute extrinsic information, i.e. the information about $d_{i,j}$ which can be obtained from all other bits in the codeword due to the code constraints. Concatenated zigzag codes can be decoded by an iterative turbo algorithm as illustrated in Fig. 34 where the constituent codes are decoded in turns taking extrinsic information of the other constituent decoders into account as additional a-priori information. Interleavers are not shown in Fig. 34 for simplicity. Each constituent decoder $l$ uses the received channel information $L_c(d_{i,j})$ and $L_c(p_{l,i})$ for the data bits and parity bits, respectively, as well as extrinsic information $L_{e,k}(d_{i,j})$ from the other constituent decoders as additional a-priori information $L_{a,l}(d_{i,j})$. Extrinsic information of a constituent decoder $l$ is defined by the difference

$$L_{e,l}(d_{i,j}) = L_{app,l}(d_{i,j}) - L_c(d_{i,j}) - L_{a,l}(d_{i,j}) \qquad (13)$$

of the output and input log-likelihood ratios. During iteration $n$, the a-priori information consists of the extrinsic information obtained in the current iteration $n$ from the already decoded constituent decoders $k=1,\ldots, l\text{-}1$ and the extrinsic information from decoders $k=l+1, \ldots, K$ which was obtained in the previous iteration $n\text{-}1$.

For the concatenation of several zigzag constituent codes, $K$-1 different interleavers are needed. In general, multiple interleavers can be generated randomly. However, apart from the fact that it cannot be guaranteed that interleavers with good mutual properties are generated, a significant practical problem appears in terms of memory requirements since each of the $K$-1 permutation pattern needs to be stored. Moreover, a system may have to support various block lengths. In this case, we have to store $K$ interleaver patterns for each possible block length. Therefore, we wish to generate multiple interleavers from a simple equation or by simple operations on a common mother interleaver.

The problem of saving memory for multiple interleavers has been addressed in the context of zigzag codes in N. Nefedov, "Multi-dimensional zigzag codes for high data rate transmission", in 3rd International Symposium on Turbo Codes and Related Topics, pp. 215-218, September 2003. and N. Nefedov, "Evaluation of low complexity concatenated codes for high data rate transmission," in 14th International Symposium on Personal, Indoor and Mobile Radio Communications, pp. 1868-1872, September 2003.

Here, it is proposed to build a multidimensional zigzag code by arranging the data bits in a cube and performing zigzag encoding in various directions through the cube. However, by doing so, the design space is limited and particularly the parameter $J$ of the constituent zigzag codes may be fixed and differ.

In N. Nefedov, "Evaluation of low complexity concatenated codes for high data rate transmission", in 14th International Symposium on Personal, Indoor and Mobile Radio Communications, pp. 1868-1872, September 2003, a proposal is presented which allows to use zigzag codes and the parallel concatenated convolutional codes as specified for UMTS within the same framework. As far as interleaving is concerned, the author proposes to use the interleaver specified for the UMTS turbo code and its transpose as the interleaver for a third concatenated constituent zigzag code. Even though this scheme is very simple, it is limited to two interleavers. It is further suggested by N. Nefedov to produce additional interleavers from the UMTS interleaver by swapping of addresses of the interleaver. However, no information is given on how this should be done.

Only a few papers on design of multiple interleavers exist and an appropriate design criterion is still an open problem.

Multiple interleavers are considered in A. Tarable, G. Montorsi, and S. Benedetto, "Analysis and design of interleavers for iterative multi-user receivers in coded CDMA systems," IEEE Transactions on Information Theory, vol. 51, pp. 1650-1666, May 2005, and S. Brück, U. Sorger, S. Gligorevic, and N. Stolte, "Interleaving for outer convolutional codes in DS-CDMA systems," IEEE Transactions on Communications, vol. 48, pp. 1100-1107, July 2000 in the context of multi-user detection in code division multiple access (CDMA) and K. Kusume and G. Bauch, "Cyclically shifted multiple interleavers," in Globecom, IEEE, November/December 2006, Kusume and G. Bauch, "Some aspects of interleave division multiple access in ad hoc networks," in 4th International Symposium on Turbo Codes and Related Topics, April 2006 or interleave division multiple access (IDMA).

Multiple interleavers for multidimensional turbo codes are proposed in A. Barbulescu and S. Pietrobon, "Interleaver design for three dimensional turbo codes," in IEEE International Symposium on Information Theory, p. 37, September 1995, N. Ehtiati, M. Soleymani, and H. Sadjadpour, "Interleaver design for multiple turbo codes," in Canadian Conference on Electrical and Computer Engineering, pp. 1605-1607, May 2003 and N. Ehtiati, M. Soleymani, and H. Sadjadpour, "Joint interleaver design for multiple turbo codes," in IEEE Vehicular Technology Conference (VTC Fall), pp. 2302-2306, September 2004. In S. Brück, U. Sorger, S. Gligorevic, and N. Stolte, "Interleaving for outer convolutional codes in DS-CDMA systems", IEEE Transactions on Communications, vol. 48, pp. 1100-1107, July 2000, the authors derive design criteria for random congruential interleavers in order to minimize the impact of multi-user interference under the condition of certain convolutional codes. A disadvantage is that if the code properties are changed, e.g. by puncturing in a rate-adaptive coding scheme, the interleavers have to be changed. Furthermore, a minimum interleaver size is required in order to meet the design criteria.

Particularly, for low rate codes this minimum interleaver size becomes prohibitively large. Another design criterion is discussed in A. Tarable, G. Montorsi, and S. Benedetto, "Analysis and design of interleavers for iterative multiuser receivers in coded. CDMA systems," IEEE Transactions on Information Theory, vol. 51, pp. 1650-1666, May 2005, where the authors use the heuristic criterion of minimizing the intersection, i.e. the set of common codewords, between the resulting codewords after interleaving.

However, it turns out those interleavers, which violate this criterion, but instead satisfy criteria on individual interleavers for good turbo processing, show a better performance. This again stresses the difficulties in finding appropriate design criteria and justifies relying more on heuristic approaches and evaluation by simulations. Furthermore, except for the case of congruential symbol interleavers in combination with convolutional codes, no construction methods are given in A. Tarable, G. Montorsi, and S. Benedetto, "Analysis and design of interleavers for iterative multi-user receivers in coded CDMA systems," IEEE Transactions on Information Theory, vol. 51, pp. 1650-1666, May 2005. The heuristic approach taken in K. Kusume and G. Bauch, "Cyclically shifted multiple interleavers," in Globecom, IEEE, November/December 2006, K. Kusume and G. Bauch, "Some aspects of interleave division multiple access in ad hoc networks," in 4th International Symposium on Turbo Codes and Related Topics, April 2006 will be explained in more detail below.

Interleaver design in the context of multidimensional parallel concatenated convolutional codes is addressed in N. Ehtiati, M. Soleymani, and H. Sadjadpour, "Interleaver design for multiple turbo codes," in Canadian Conference on Electrical and Computer Engineering, pp. 1605-1607, May 2003 and N. Ehtiati, M. Soleymani, and H. Sadjadpour, "Joint interleaver design for multiple turbo codes," in IEEE Vehicular Technology Conference (VTC Fall), pp. 2302-2306, September 2004. Here, the fact that data sequences, which are divisible by the feedback polynom of the recursive convolutional constituent codes, produce low weight codewords is taken into account. The interleaver should permute those divisible patterns to non-divisible patterns. In order not to put to many restrictions on one interleaver, the idea in N. Ehtiati, M. Soleymani, and H. Sadjadpour, "Interleaver design for multiple turbo codes," in Canadian Conference on Electrical and Computer Engineering, pp. 1605-1607, May 2003, N. Ehtiati, M. Soleymani, and H. Sadjadpour, "Joint interleaver design for multiple turbo codes," in IEEE Vehicular Technology Conference (VTC Fall), pp. 2302-2306, September 2004 is that each interleaver takes care of a subset of critical patterns which have to be broken. This ensures that at least one constituent code contributes weight to the codeword. However, the design criteria are limited to parallel concatenated convolutional codes and depend on the particular choice of the constituent codes. Furthermore, no simple construction method is given which would allow low cost implementation. The proposal in A. Barbulescu and S. Pietrobon, "Interleaver design for three dimensional turbo codes", in IEEE International Symposium on Information Theory, p. 37, September 1995 is limited to parallel concatenation of three convolutional codes and focuses on small block lengths. Here, the goal is to ensure that all constituent codes terminate in the same state.

Congruential interleavers offer a straightforward approach, which allows constructing multiple interleavers for different block lengths from a simple equation. However, congruential interleavers introduce limited randomness, which results in sub-optimum performance.

A simple method to construct multiple interleavers is to use congruential interleavers with different seed. The permutation rule of a congruential interleaver is given by S. Crozier, J. Lodge, P. Guinand, and A. Hunt, "Performance of turbo-codes with relative prime and golden interleaving strategies", in International Mobile Satellite Conference, pp. 268-275, 1999

$$\Pi_k(n) = s_k + nc_k \mod N, n = 0,...,N-1, \qquad (14)$$

where $s_k$ is an integer starting value, $N$ is the interleaver size and $c_k$ is an integer, which must be relatively prime to $N$ in order to ensure a unique mapping. Multiple interleavers can be generated by using different $c_k$ and $s_k$. The values of $c_k$ may be chosen such that adjacent bits in the data sequence are mapped to positions with a predetermined minimum spacing of s bits. In this case, the interleaver is called an s-random congruential interleaver.

Generating multiple interleavers from one common mother interleaver using cyclic shifts and self-interleaving was proposed in K. Kusume and G. Bauch, "Cyclically shifted multiple interleavers," in Globecom, IEEE, November/ December 2006, K. Kusume and G. Bauch, "Some aspects of interleave division multiple access in ad hoc networks," in 4th International Symposium on Turbo Codes and Related Topics, April 2006 in the context of interleave division multiple access (IDMA) where users with low rate FEC coding are separated by different interleavers. The advantage is that only a single interleaving pattern has to be stored. Other interleavers can be constructed if needed based on very few parameters, i.e. the cyclic shifts. The use of cyclic shifts for generation of multiple interleavers is motivated by an observation for multi-user detection which showed that a synchronism between users, i.e. the user's signals arrive with different delay at the multi-user receiver, allows to separate them as well as user-specific random interleavers even if the same interleaver is used for all users K. Kusume and G. Bauch, "Cyclically shifted multiple interleavers", in Globecom, IEEE, November/December 2006. It was proposed to construct the interleaving pattern $\Pi_k$ for user $k$ from a common interleaver $\Pi$ by user-specific cyclic shifts $\Delta_{k,c}$ and interleaving of the permutation pattern by itself as indicated in Fig. 35. With about $D = 3$ such cyclic shifts and self-interleaving operations, the same performance as with randomly chosen interleavers could be obtained in IDMA with synchronous users.

It is the object of the present invention to provide an encoder and a decoder for zigzag codes, which provide improved performance.

The object is achieved by an encoder according to claim 1, a method for encoding according to claim 14, a decoder according to claim 16 and a method for decoding according to claim 17.

The present invention is based on the finding that enhanced performance of a communication system utilizing concatenated zigzag codes can be obtained, when interleaving rules are adapted to the properties of zigzag codes. In one embodiment the minimum Hamming distance of an overall code is increased by the interleaving rule. In one embodiment the input codeword is segmented and the interleaver ensures that bits, which are within one segment at the input of a certain constituent encoder, are not mapped to the same segment or adjacent segments at the input of any other constituent encoder.

The embodiments therefore provide an optimized performance, as worst case patterns for zigzag codes are avoided. Common mappings of different interleavers are avoided as well. Furthermore, implementation complexity of embodiments is lower than that of prior art concepts, as the interleaver generation is more structured. Small subinterleavers require less memory and allow parallel implementation. Furthermore small subinterleavers allow for even lower memory requirements if a common mother interleaver is used for all subinterleavers.

Details of Embodiments are described using the figures enclosed, in which

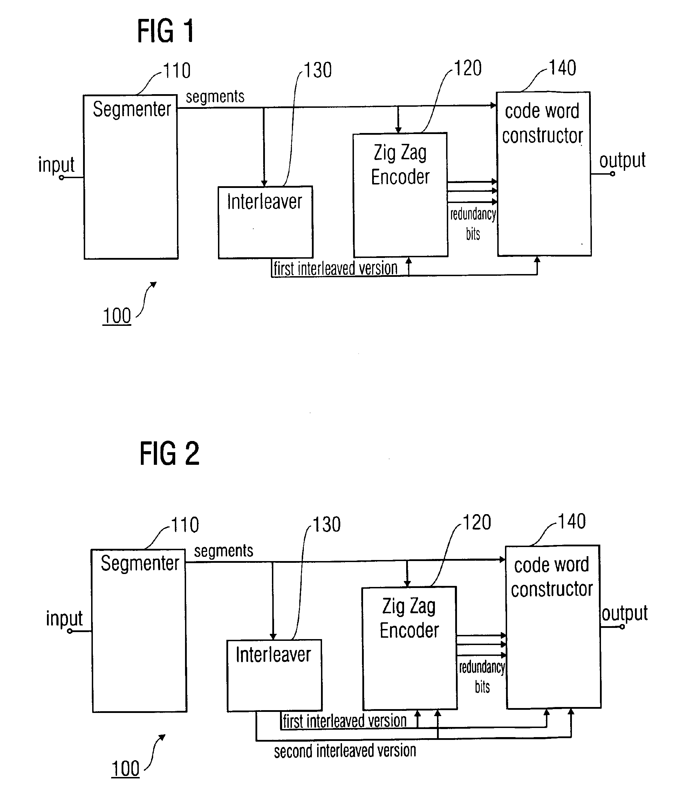

Fig. 1 shows an embodiment of an encoder;

Fig. 2 shows another embodiment of an encoder;

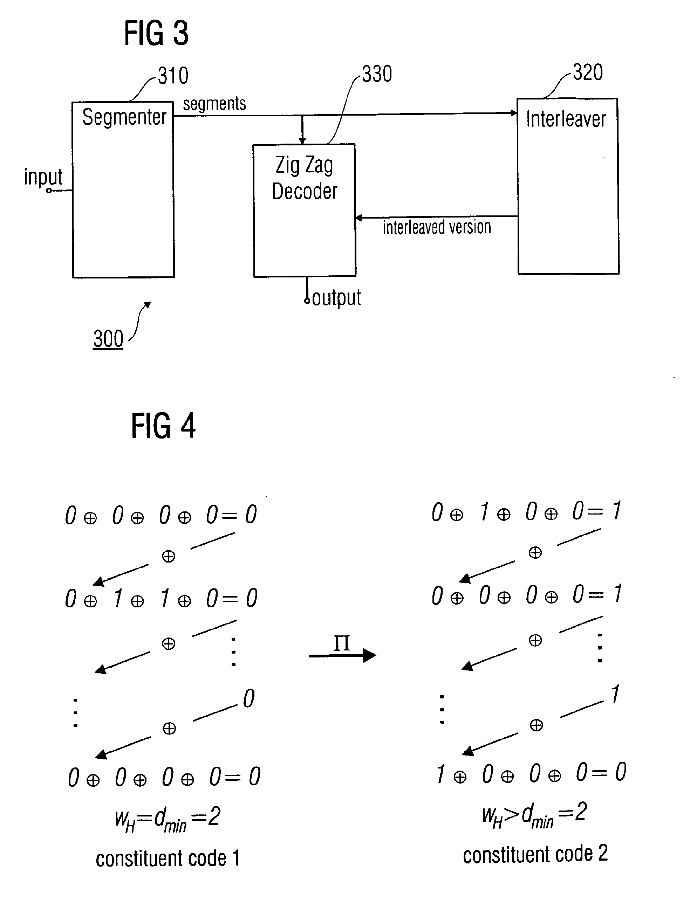

Fig. 3 shows an embodiment of a decoder;

Fig. 4 shows a codeword with minimum Hamming distance $d_{min}$ = 2 and an optimized version;

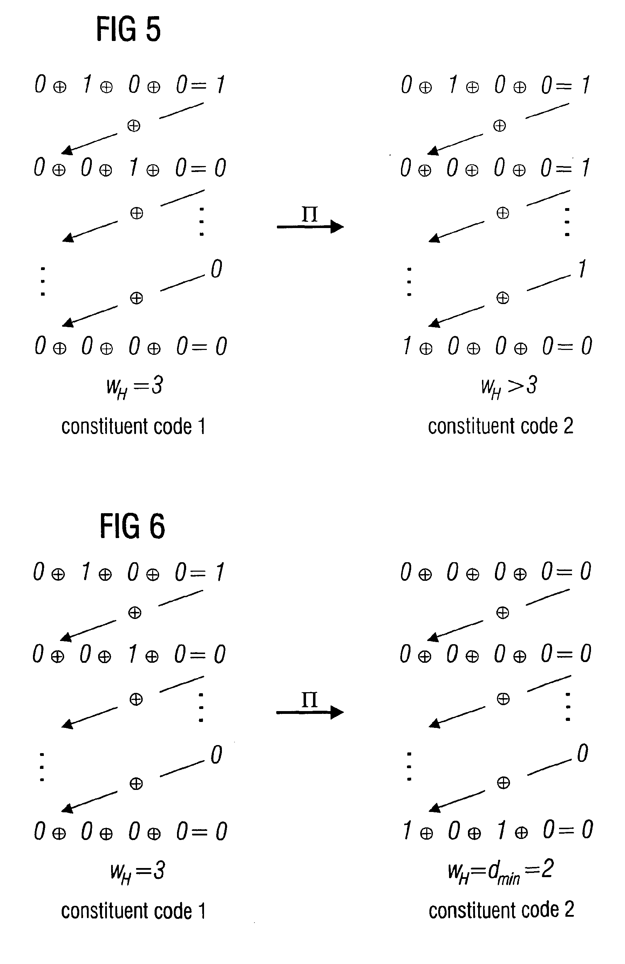

Fig. 5 shows a codeword with a Hamming weight of $W_H$ = 3 and an optimized version;

Fig. 6 shows a codeword with a Hamming weight of $W_H$ = 3 and a version obtained with a sub-optimum interleaver;

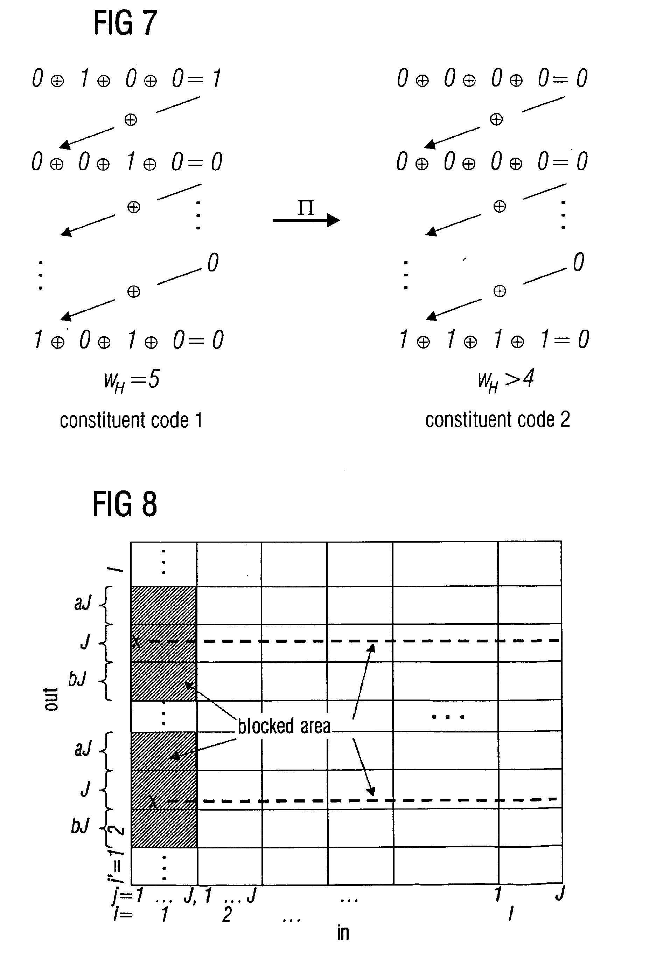

Fig. 7 shows a codeword with a Hamming weight of $W_H$ = 5 and an interleaved version;

Fig. 8 shows an embodiment of a construction of an interleaver;

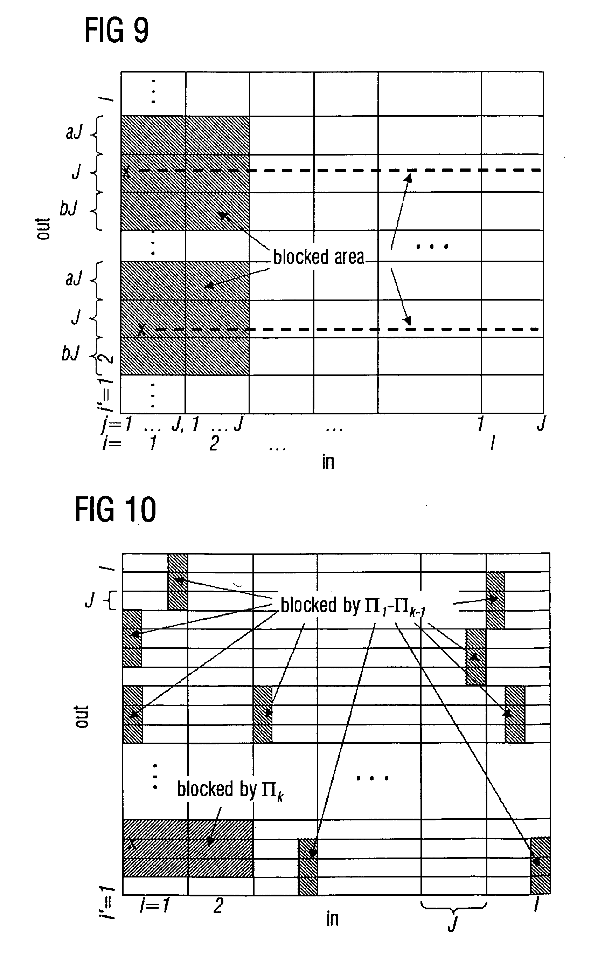

Fig. 9 shows another embodiment of a construction of an interleaver;

Fig. 10 shows a further embodiment of a construction of an interleaver;

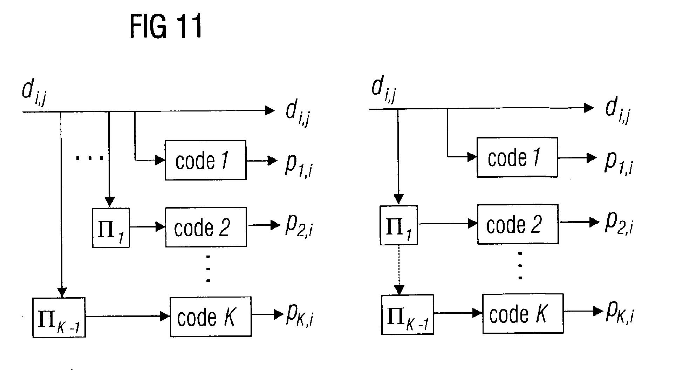

Fig. 11 shows two alternative embodiments of encoders;

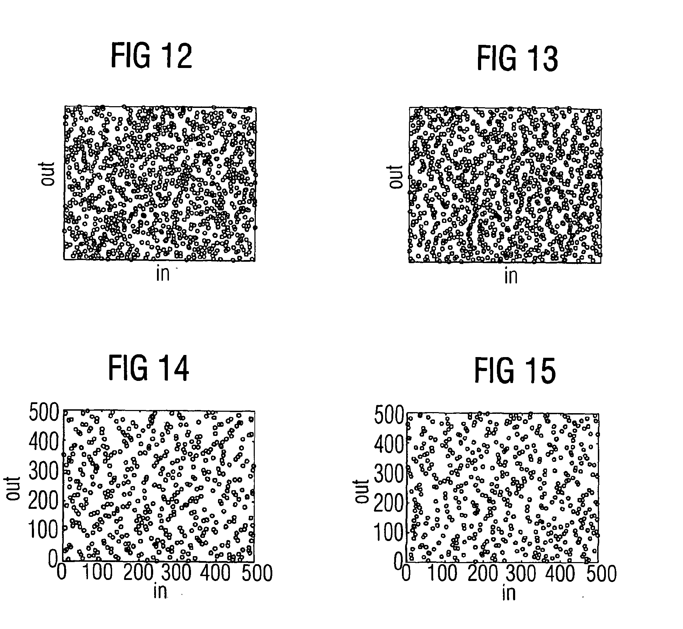

Fig. 12 shows an illustration of an embodiment of an interleaving rule;

Fig. 13 shows another embodiment of an interleaving rule;

Fig. 14 shows another embodiment of an interleaving rule;

Fig. 15 shows a further embodiment of an interleaving rule;

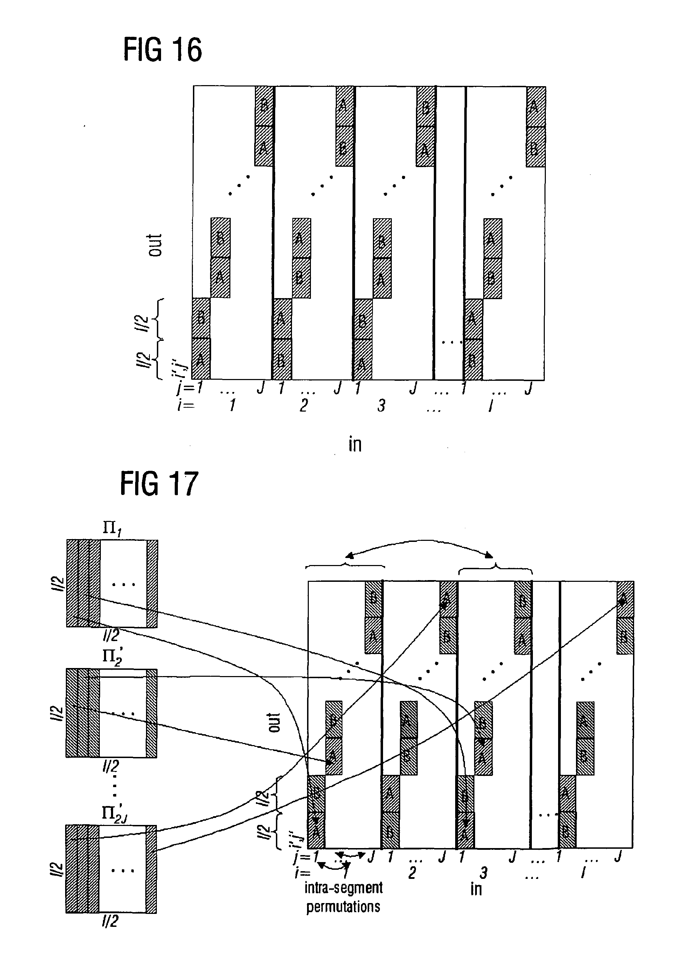

Fig. 16 shows a further embodiment of a construction of an interleaver;

Fig. 17 shows a further embodiment of a construction of an interleaver;

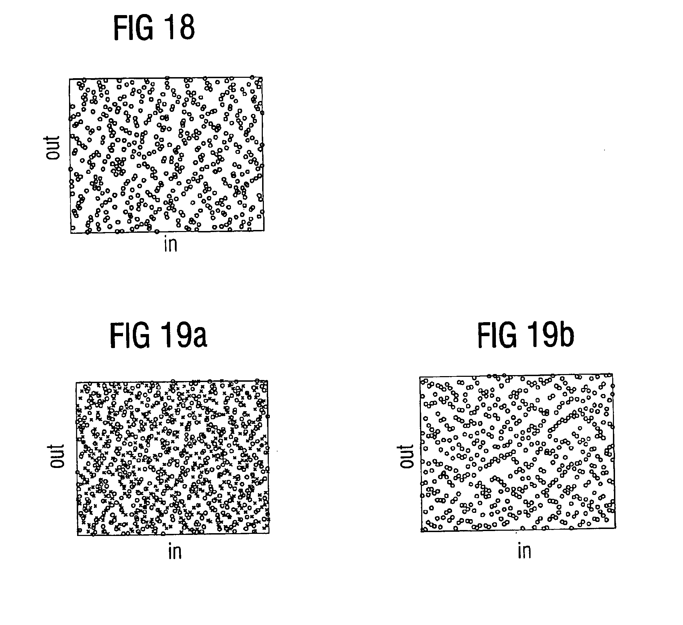

Fig. 18 shows a view graph of an embodiment of an interleaving rule;

Figs. 19a and 19b show view graphs of embodiments of interleaving rules;

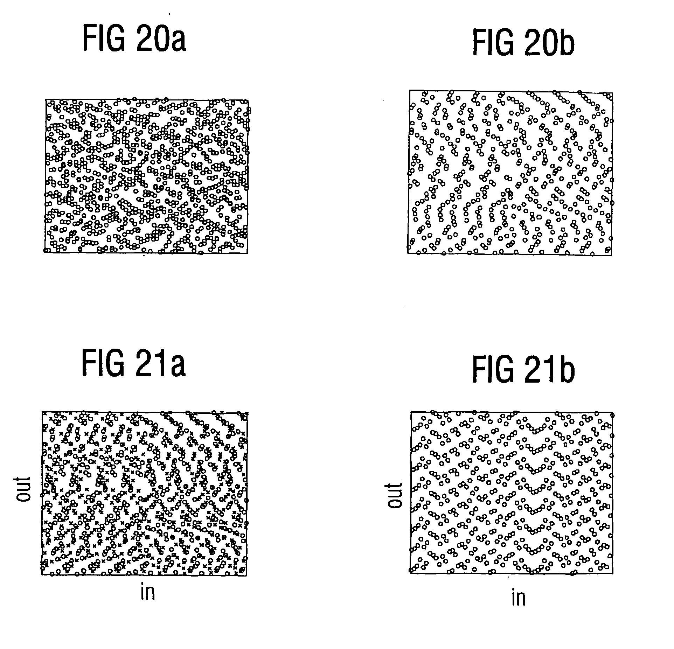

Figs. 20a and 20b show view graphs of embodiments of interleaving rules;

Figs. 21a and 21b show view graphs of embodiments of interleaving rules;

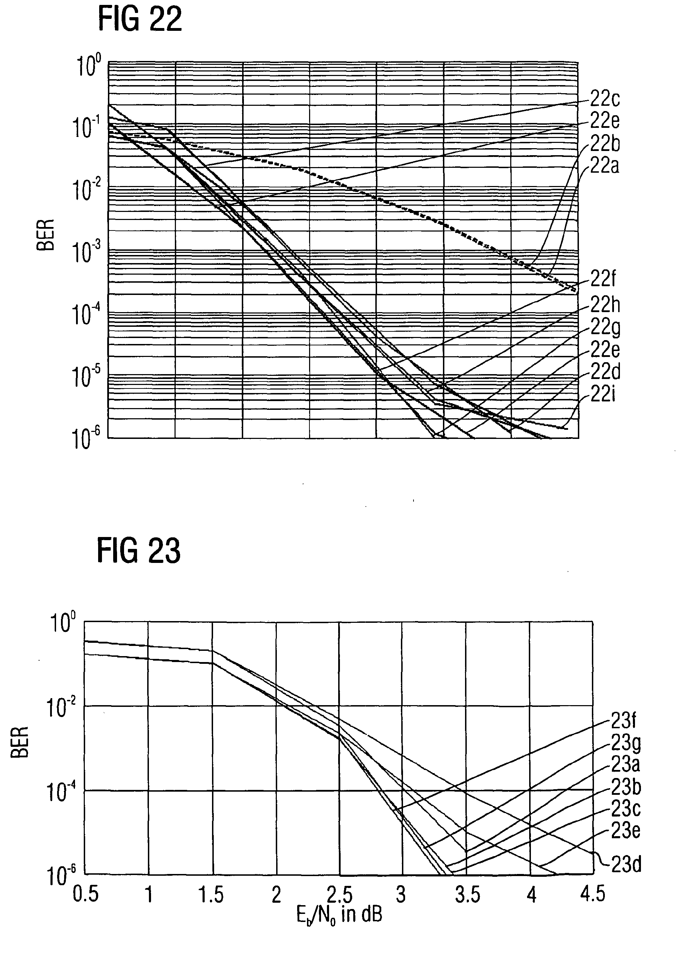

Fig. 22 shows a view graph of bit error rates obtained with an embodiment;

Fig. 23 shows another view graph of bit error rates obtained with an embodiment;

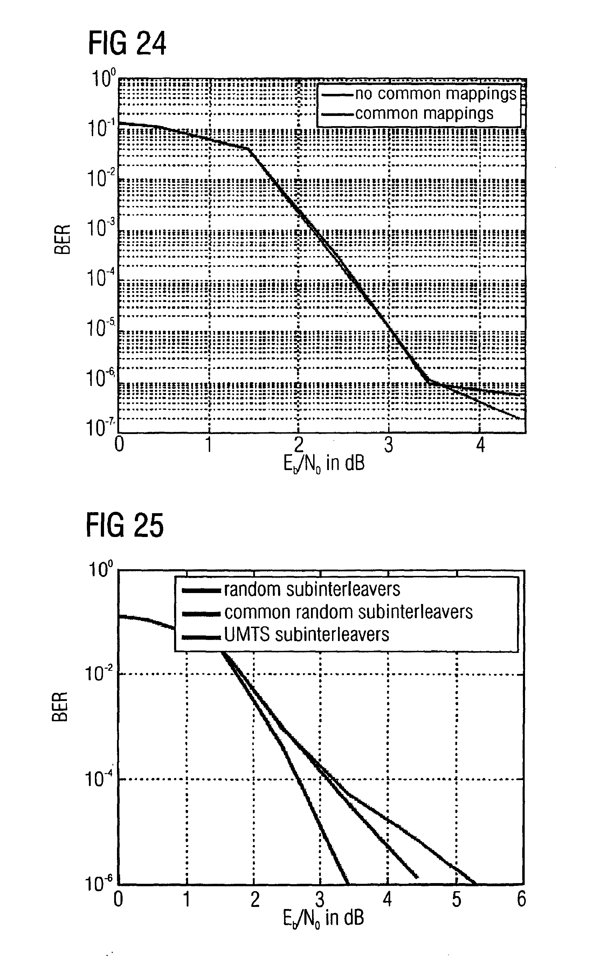

Fig. 24 shows a view graph of bit error rates obtained with an embodiment with and without common mappings;

Fig. 25 shows view graphs of bit error ratios obtained with different embodiments;

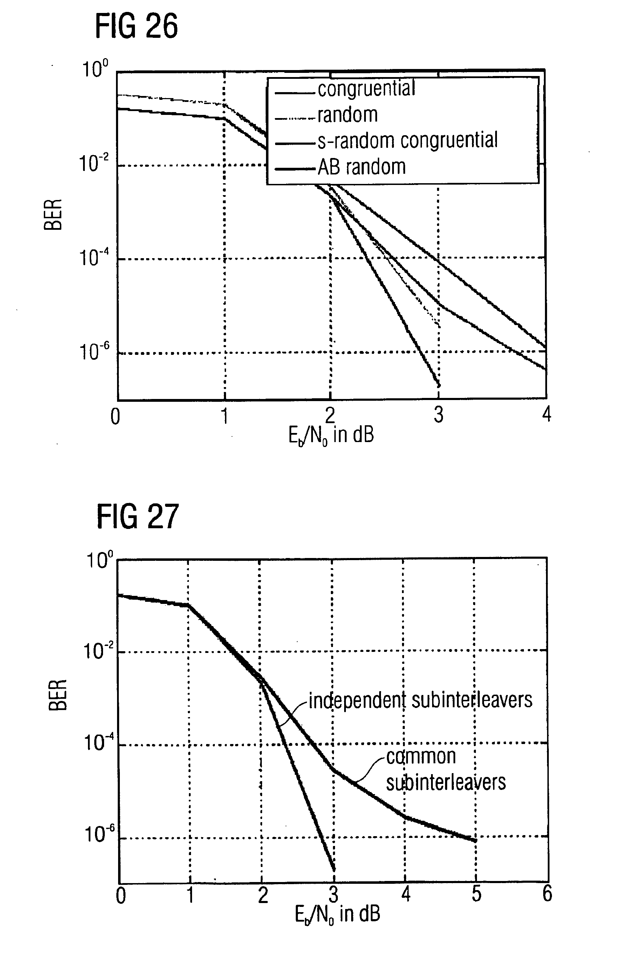

Fig. 26 shows view graphs of bit error ratios obtained with different interleavers;

Fig. 27 shows view graphs of bit error ratios of zigzag codes with an embodiment of an AB interleaver;

Fig. 28 illustrates a state of the art zigzag code;

Fig. 29 illustrates a state of the art zigzag encoder;

Fig. 30 shows a zigzag codeword with a minimum Hamming distance $d_{min}$=2;

Fig. 31 shows a zigzag codeword with a Hamming distance of 3;

Fig. 32 shows a state of the art encoder for concatenated zigzag codes;

Fig. 33 illustrates the design criteria for concatenated zigzag codes;

Fig. 34 shows a state of the art decoder for concatenated zigzag codes;

Fig. 35 shows a state of the art interleaving rule with cyclic shifts.

Fig. 1 shows an encoder 100 for generating an output codeword based on an input information word, the input information word having fewer bits than the output codeword. The encoder 100 comprises a segmenter 110, a zigzag encoder core 120, an interleaver 130, and an output codeword constructor 140.

The segmenter 110 is adapted for segmenting the input information word into a plurality of ordered segments, the segments having bits. The zigzag encoder 120 is designed for calculating a redundancy bit for a current segment, wherein a redundancy bit of an earlier segment in the order is used when calculating the redundancy bit for the current segment. The encoder 100 comprises the interleaver 130 for interleaving the bit of the plurality of segments using an interleaving rule to obtain an interleaved version. The output codeword constructor 140 is adapted for constructing the output codeword using the input codeword or the interleaved version thereof and a set of redundancy bits generated by the zigzag encoder core 120, fed by the interleaved version, wherein the interleaver 130 is adapted to use the interleaving rule such that for at least 50% of all segments of the input information word bits of the input information word within the same segment are relocated to at least one different segment of the interleaved version.

In another embodiment, the output codeword constructor 140 is adapted for constructing the output codeword further using redundancy bits generated by the zigzag encoder core 120 fed by the input codeword. In another embodiment, the interleaver 130 is adapted for obtaining a further interleaved version of the bits of the plurality of segments using a further interleaving rule and the output codeword constructor 140 is adapted for constructing the output codeword using redundancy bits generated by the zigzag encoder core 120 fed by the further interleaved version.

In yet another embodiment the interleaver 130 is adapted for using an interleaving rule being such that two bits being located in the same segment of the input information word are relocated to separate segments in the interleaved version. In another embodiment, the interleaver 130 may be adapted for using an interleaving rule, being such that two bits being located in adjacent segments of the input codeword are separated by at least two segments in the interleaved version.

In other embodiments, the interleaver 130 can be adapted for using an interleaving rule being such that two output codewords being constructed using two interleaved versions of input information words and two sets of redundancy bits generated by the zigzag encoder fed by the two interleaved versions, have a higher minimum Hamming weight than the input information word. In one implementation the minimum Hamming weight between any two output codewords may be larger than 2.

Embodiments may have the interleaver 130 being adapted using an interleaving rule which comprises a sub-step of randomly assigning to a position of a bit in the input information word a position in the interleaved version. In another embodiment, the interleaving rule may comprise a sub-step of randomly assigning to a position of a bit in the input information word, a position from an allowed region in the interleaved version, the allowed region having a certain distance to positions of bits that have been previously assigned. The allowed region may be determined from all positions in the interleaved version, but blocked regions may be positioned having been assigned previously or establishing a certain distance to previously assigned positions from a certain segment.

In another embodiment the interleaver 130 may be adapted for providing at least two interleaved versions based on an interleaving rule and a further interleaving rule, the further interleaving rule being such that at least the position of 10% of the bits from the input information word are assigned to positions in the further interleaved version, which are different from the position they are assigned to in the interleaved version. The interleaver 130 may be adapted for obtaining the further interleaved version by interleaving the interleaved version. The interleaver 130 can also be adapted for using an interleaving rule, based on assigning random positions within predefined regions from the interleaved version to positions of the input information word. The interleaver 130 can be operative for further interleaving the predefined regions.

Fig. 2 shows another embodiment of an encoder 100 comprising the segmenter 110, the zigzag encoder core 120, the interleaver 130, and the codeword constructor 140. In the embodiment shown in Fig. 2, the interleaver is adapted for providing a further interleaved version to the zigzag encoder core 120 and the codeword constructor 140. The zigzag encoder 120 may be adapted for providing additional redundancy bits based on the segments received from the segmenter 110 and at the further interleaved version received from the interleaver 130. Accordingly, the codeword constructor 140 can be adapted for providing an output codeword, being based on the segments received from the segmenter 110, the interleaved version or the further interleaved version received from the interleaver 130, and the redundancy bits received from the zigzag encoder, referring to the segments from the segmenter 110, the interleaved version or the further interleaved version received from the interleaver 130.

Fig. 3 shows a decoder 300 for decoding an input codeword and for generating an output information word, the output information word having fewer bits than the input codeword. The decoder 300 comprises a segmenter 310, an interleaver 320 and a zigzag decoder 330. The segmenter 310 is adapted for segmenting the input codeword into a plurality of ordered segments, a segment having information bits and redundancy bits. The decoder 300 comprises the interleaver 320 for interleaving the information bits of the plurality of segments, using an interleaving rule to obtain an interleaved version of the information bits, wherein the interleaver 320 is adapted to use the interleaving rule being such that for at least 50% of all segments of the input information word bits of the input information word within the same segment, are relocated to at least one different segment of the interleaved version. The decoder 300 comprises the zigzag decoder 330 for calculating the output information word based on the information bits, the interleaved version of the information bits and the redundancy bits.

Embodiments take the requirements of concatenated zigzag codes explicitly into account in the construction of interleavers. According to L. Ping, X. Huang, and N. Phamdo, "Zigzag codes and concatenated zigzag codes", IEEE Transactions on Information Theory, vol. 47, pp. 800-807, February 2001, the asymptotic performance of a concatenated zigzag code is determined by low weight codewords of the overall code. Embodiments provide the advantage that those low weight codewords do not occur as the minimum Hamming distance will be increased in the concatenated code, whilst providing sufficient randomness by the interleavers. Embodiments avoid codewords with weight $w_H = 2$. Codewords with Hamming weight $w_H = 2$ occur, if the original data sequence has only two bits with value $d_{i,j} = 1$, which are located within the same segment and which are mapped to the same segment by the interleaver, as it is shown in Fig. 4.

A codeword with a minimum Hamming distance of $w_H = d_{min} = 2$ is shown on the left hand side and labeled as "constituent code 1". On the right hand side, another codeword is depicted in Fig. 4, which is labeled "constituent code 2" and which results from the interleaving rule $\Pi$. It can be observed that the Hamming distance was increased. Embodiments provide interleaving rules according to the rule $\Pi$ of Fig. 4. Embodiments therefore map data bits, which are within the same segment in the original sequence to different segments in the interleaved version. Similar to what was explained using Fig. 4, the weight of a resulting codeword would be higher the farther the segments to which the two bits with value 1 are mapped are separated. In other embodiments this can be taken into account to carry out even harder interleaver restrictions, e.g. that bits, which are within one segment in the original sequence, are mapped to different segments with a minimum separation of a least B segments.

In another embodiment care is also taken about codewords with the second smallest possible Hamming weight $w_H = 3$. Those codewords are generated if the data sequence contains two bits with value 1, which are located in adjacent segments as indicated on the left hand side of Fig. 5, labeled as "constituent code 1". Fig 5 shows on the left hand side again a zigzag encoded codeword with a Hamming weight of 3. Embodiments provide an interleaving rule $\Pi$, which maps the codeword from the left hand side to the right hand side of Fig. 5, labeled as "constituent code 2". It can be observed that the Hamming weight is increased. The two 1-bits are spread farther apart by the interleaver. Particularly, a situation as shown in Fig. 6 is avoided, where on the left hand side of Fig. 6 the same codeword as on the left hand side of Fig. 5 is shown, however the interleaving rule used in Fig. 6 maps the codeword with Hamming weight $w_H = 3$ to a codeword with the minimum Hamming distance. Embodiments avoid these disadvantageous mappings.

Embodiments are focused mainly on the low Hamming weight codewords. Therefore, in another embodiment a situation, as depicted in Fig. 7 may occur, where a codeword with a rather large Hamming weight of $w_H = 5$ ("constituent code 1") is disadvantageously mapped to a codeword with a Hamming weight of $w_H = 4$ ("constituent code 2"), however, these codewords do not determine the asymptotic performance of a concatenated zigzag code. Furthermore, in a concatenated zigzag code only the parity bits of the constituent codes are transmitted, and no further weight is created by the concatenated constituent code in the overall codeword. Since in the example of Fig. 7, the non-interleaved data word creates already a weight of $w_H = 5$ codeword, it is not the most critical case. Furthermore, the more bits with value 1 are contained in the data sequence, the less likely is a constellation, where those 1-bits are mapped to the same segment by one or even all interleavers. Embodiments can have two main design criteria, which can be summarized as:

   1. Bits that are located in the same segment in the interleaver input sequence should be mapped to different segments, which are separated by at least *B* segments, where $B \geq 1$ is a design parameter.

   2. Bits that are located in adjacent segments in the interleaver input sequence should be mapped to different segments, which are separated by at least *n* segments, where $n \geq 2$ is a design parameter.

In one embodiment a random interleaver construction with restrictions may be carried out. This approach is illustrated in Fig. 8, where the mapping of the indices of an input sequence to the indices of an output sequence is shown. It is supposed that the input sequence is segmented into I segments, of which each contains J elements. In Fig. 8, these indices are indicated on the abscissa, labeled by "in". On the ordinate in Fig. 8 the output indices are given which correspond again to I segments, each containing J elements labeled by "out". Consequently the abscissa denotes the indices of the interleaver input sequence and the ordinate denotes the indices of the output sequence.

The input indices are successively mapped to output indices starting from index (i,j) = (1,1) up (i,j) = (I, J). The first index (i, j) = (1, 1) is randomly mapped to an index (i',j'). The (i',j')-th row is marked as blocked area such that no further input indices are mapped to the same output index. In order to meet the above mentioned criterion 1, an area within the first segment i = 1 consisting of a predetermined number aJ of rows above and bJ below the J-th row are blocked, which belong to the assigned segment i' as indicated in Fig. 8. Embodiments may choose a = b = k. Next, the next index (i, j) = (1, 2) is mapped to (i', j'), where (i', j') cannot be located in the blocked area. This ensures that all bits which are located within the same segment at the interleaver input are mapped to different segments which are separated by at least B = min{a, b} segments. All further indices are assigned accordingly.

In order to meet also the abovementioned criterion 2, the respective rows above and below segment i' for the two segments i and i+1 of the input sequence can be blocked, as depicted in Fig. 9. Fig. 9 shows the same input/output index mapping view graph as described for Fig. 8, indicating the blocked area reaching also to i + 1. This ensures that data bits which are located in two adjacent segments of the input sequence are mapped to segments which are separated by at least B = min{a, b} segments. Note that the interleaver construction is impossible if (2J - 1) (a + b + 1) > I. In order to enable convergence of the embodiment methods,

$$2(J-1)(a+b+1) << \text{I} \; . \qquad (16)$$

In short, one interleaver construction embodiment can be summarized as follows:

```
for i = 1:I
    for j = 1:J
        • Choose randomly an index pair (i', j') from
          the set of (i', j') which are not blocked in
          column (i, j).
        • Mark row (i', j') as blocked.
        • Mark entries (i', j'), (i, j) as blocked for
          i = i, i + 1, j = 1, ..., J, i' = i' - a,
          ..., i' + b, j' = 1, ..., J.
```

end for *j* end for *i*.

So far embodiments have been described enabling the construction of one interleaver. Embodiments also allow construction of mutually independent interleavers. In one embodiment the criterion for "mutually independent" might be that the constructed interleavers have no mappings in common. Embodiments achieve this criterion by starting the construction of k-th interleaver $\Pi_k$ with a blocked area, which consists of a part of the blocked area from previously constructed interleavers $\Pi_1$ to $\Pi_{k-1}$. In one embodiment, in each column the index pairs (i', j') to which the input index pair (i, j) of the respective column has been mapped by previously constructed interleavers $\Pi_1$ to $\Pi_{k-1}$ as well as a predetermined number of m, m ≥ 0 elements above and below those index pairs (i', j') as indicated in Fig. 10. Fig. 10 shows the same assignments scheme as Figs. 8 and 9, however, extra regions are blocked in order to avoid common mappings with previous interleavers $\Pi_1$ to $\Pi_{k-1}$. If this blocking results in a situation during construction of interleaver $\Pi_k$, where no output index pair can be assigned for a particular input index pair, then the blocking which is due to previously assigned interleavers $\Pi_1$ to $\Pi_{k-1}$ is deleted for this column. If still no mapping can be found, then also the blockings set during construction of the current interleaver $\Pi_k$ are deleted. Alternatively, in one embodiment, constructions of the current interleaver $\Pi_k$ can be restored from the beginning with a new seed of a random generator.

The embodiments described above use the original data sequence as a reference. However, we do not ensure that higher weight data sequences, which are mapped by the first interleaver $\Pi_1$ to a sequence which does not increase the weight of the overall codeword as e.g. in the example depicted in Fig. 7, are mapped to sequences which generate additional weight by further interleavers $\Pi_2$ to $\Pi_{K-1}$. Embodiments can achieve this by an encoder structure as depicted in Fig. 11 on the right hand side. Where in contrast to the structure on the left hand side, the interleaver $\Pi_k$ operates on the permutated sequence at the output of the interleaver $\Pi_k$, rather than on the original sequence.

For higher input index pairs (i, j), the degrees of freedom are reduced due to the already put restrictions. Embodiments can take this into account if the starting index for each constructed interleaver $\Pi_k$ is changed. In one embodiment, the algorithm is (i, j) = (1, 1) for odd k whereas for even k the reverse order is taken, i.e. it is started at the highest index pair (i, j) = (I, J). In one embodiment even more randomization can be achieved by choosing the next index pair (i, j) randomly at each step. In this embodiment, the respective rows are not only blocked for input segments i and i + 1, but also for segment i - 1 in order to meet the abovementioned criterion 2.

Graphical representations of random interleavers according to the above embodiments are shown in Figs. 12 to 15. In each of these figures, two view graphs of two interleavers $\Pi_1$ and $\Pi_2$ are depicted. $\Pi_1$ is depicted with dark circles and $\Pi_2$ is depicted with gray circles. Figs. 12 and 13 show view graphs for I = 128 segments, each comprising J = 4 elements, with blocked areas sizes of a = b = 2 for Fig. 12 and a = b = 4 for Fig. 13. Figs. 14 and 15 show the view graphs for I = 256 segments, each comprising J = 4 elements, and a = b = 8. The construction of $\Pi_2$ starts at (i,j)= (I,J) in Fig. 15, and with (i,j) = (1,1) in Fig. 14. It can be observed that good randomization is achieved and that there are no common mappings of the two interleavers $\Pi_1$ and $\Pi_2$. The spread is better the larger a and b are chosen.

Other embodiments are carried out in a more structured algorithm for generating the interleavers, which meet the requirements for zigzag codes. Similar to what was described above, a view graph depicted in Fig. 16 is used to detail the embodiment. Fig. 16 shows a square interleaver representation, where the abscissa denotes the indices of the interleaver input sequence and the ordinate denotes the indices of the output sequence. In order to avoid worst-case patterns, areas of allowed mappings are blocked. In order to map bits, which are located in the same segment in the original sequence to different segments in the output sequence, an allowed area of A segments for the mapping of each input bit is shown in Fig. 16. The allowed areas of two bits in the input segment shall be separated by at least B segments. Therefore, the allowed area of A segments for the j-th bit in each input segment I starts with output segment I' = (j-1)•(A+B) +1, j = 1, ...J, for odd numbered segments i. For even numbered segments $i$, the allowed areas are shifted upwards by $B$ segments in order to obtain a unique mapping to all output index pairs. For the sake of simplification of ensuring unique mappings, the exemplified embodiments are restricted here to the case $A = B = I/2$. Generally all other mappings are conceivable within other embodiments. Here it is implied that I/2 is a multiple of J, in the general case arbitrary mappings are conceivable.

In this embodiment, all input bits, which share the same allowed area are stacked to one block and interleaved by an interleaver of $I/2$ as indicated in Figure 17. For these interleavers $\Pi'_1$ to $\Pi'_{2J}$ identical interleaving rules or any other interleaving rule, for example, random interleavers, congruential interleavers or interleavers as specified for the UMTS turbo code, can be used. The interleavers $\Pi'_1$ to $\Pi'_{2J}$ can be identical or different. Using several smaller interleavers yields the advantage of lower required memory for the permutation pattern or lower effort for the interleaver construction, respectively, as well as a relaxation of the memory access collision problem. The disadvantage is a reduced interleaver size and, hence, less randomization effect. The permutation patterns of the interleavers $\Pi'_1$ to $\Pi'_{2J}$ are then remapped to the full interleaver pattern as indicated in Figure 17.

Further randomization can be obtained by doing intra-segment permutations in one embodiment, i.e. permutations of columns within one segment $i$ and segment permutations, i.e. groupwise permutations of column groups of size $J$, which belong to the same input segment $i$. Those permutations can be done pseudo randomly or according to any deterministic rule. However, embodiments make sure for the segment permutation that odd segments $i$ are only exchanged with odd segments and even segments are only exchanged with even segments.

Embodiments easily generate multiple interleavers by doing different column permutations. A further embodiment, but a slightly more complex method for obtaining multiple interleavers, is using different size $I/2$ interleavers $\Pi'_1$ to $\Pi'_{2J}$ .

Embodiments generate interleavers in this way, which guarantee that worst-case patterns are avoided. The above mentioned criterion 1 is met, and it is guaranteed that bits of adjacent segments are not mapped to the same segment in order to avoid a situation as indicated in Fig. 6. Some embodiments do not completely meet the abovementioned secondary criterion 2, i.e. in some embodiments bits of adjacent segments are not spread farther apart as suggested in Figure 5.

Fig. 18 shows a representation of an AB interleaver with random subinterleavers and random inter and intra segment interleaving. Again, output indices versus input indices are depicted for an interleaver with I = 128 segments and J = 4 elements per segment. It can be observed that a good randomization is obtained. Fig. 19a and 19b show two graphical representations of an AB interleaver where Fig. 19a depicts two interleavers, $\Pi_1$ (crosses) and $\Pi_2$ (circles), with I= 128 segments and J = 4 elements per segment. Again, where random subinterleavers and random inter- and intra-segment interleaving was used, good randomization can be observed in Fig. 19a. Fig. 19b depicts a graphical representation of an AB interleaver with random subinterleavers and no inter and intra segment interleaving. Again output indices versus input indices are displayed for an interleaver with I = 128 segments and J = 4 elements per segment. Fig. 20a depicts a graphical representation of an AB interleaver with random subinterleavers and no inter and intra segment interleaving for two interleavers, $\Pi'_1$ and $\Pi'_2$, for similar dimensions. Fig. 20b shows a graphical representation of an AB interleaver with UMTS subinterleavers and random inter and intra segment interleaving for the same dimensions. Fig. 21a shows two interleavers, $\Pi'_1$ (crosses) and $\Pi'_2$ (circles), for the same dimensions and for the AB interleaver with UMTS subinterleavers and random inter and intra segment interleaving. Fig. 21b shows the result for a single interleaver without inter and intra segment interleaving. Both Figs. 21a and 21b use the same dimensions as Figs. 18, 19a, 19b, 20a, and 20b. From these figures, it can be observed that a good randomization can be achieved with the AB interleaver.

For a bit error rate performance (BER), a comparison of the various interleavers mentioned above is considered using a zigzag code with I = 256 segments and J = 4 elements per segment. The bit error ratio with K = 3, i.e. two interleavers, is depicted in Fig 22. Fig. 22 shows view graphs for several interleavers, which are a cyclic random with one cyclic shift 22a, a cyclic UMTS with one cyclic shift 22b, a random interleaver 22c, a congruential interleaver 22d, an s-random congruential interleaver 22e, a zigzag random interleaver 22f, a AB random interleaver 22g, a cyclic UMTS interleaver with D = 3 shifts 22h and a cyclic random interleaver with D = 3 cyclic shifts 22i. From Fig. 22 it can be observed that cyclic shifted interleavers require D = 3 cyclic shifts and self-interleaving operations for good performance. Cyclic shifted interleavers with a random mother interleaver or the UMTS interleaver as mother interleaver perform similar with a slight advantage of the UMTS based interleaver in the error floor region. Congruential interleavers show relatively poor performance. However, an s-random interleaver with the choice s = 2 · J + 1 performs very well. It shows almost the same performance as the restricted random interleaver as an embodiment. The AB interleaver as another embodiment performs slightly worse in the waterfall region. This is due to the poorer randomization effect of the small subinterleavers. It shows its best performance in the error floor region.

Fig. 23 shows another set of view graphs of different interleavers for K = 4, i.e. with 3 interleavers for the same configuration as it was used to determine Fig. 22. Fig. 23 shows a random interleaver 23a, a cyclic random interleaver with D = 3 cyclic shifts 23b, a cyclic shifted UMTS interleaver with D = 3 cyclic shifts 23c, a congruential interleaver 23d, and s-random congruential interleaver 23e, a zigzag random interleaver with common mappings 23f, and an AB random interleaver 23g. From Fig. 23 it can be observed that the zigzag random interleaver in the AB random interleaver outperformed the other interleavers, pointing out the advantages of embodiments.

Fig. 24 shows another view graph of the bit error ratio, where the impact of common mappings of the interleaver patterns $\Pi_1$ to $\Pi_2$ for a random interleaver with restrictions according to embodiments is investigated. The BER performance is compared when no common mappings of $\Pi_1$ to $\Pi_2$ are allowed to the performance without this restriction. A difference can only be observed in the error floor region, where the interleavers with no common mappings show better performance.

Fig. 25 shows another BER performance comparison of variants of the AB interleavers, according to embodiments. Random intra and inter segment permutations were used in all view graphs. Again, a configuration of I = 256 segments with J = 4 elements per segment and K = 3 parity bits was chosen. The best performance is obtained with different random subinterleavers. For comparison, results are also shown for the UMTS interleaver and for a common random interleaver being used for all subinterleavers in the construction of all interleavers $\Pi_K$. The reduced randomization effect results in performance degradation. However, construction complexity in memory requirements are significantly reduced.

Fig. 26 shows another BER performance view graph with a higher number of interleavers, i.e. K = 4. In contrast to the case of K = 3, s-random congruential interleavers perform significantly worse than those of embodiments. The congruential construction rule fails to provide mutual randomness between different interleavers. When comparing variants of the AB interleavers according to embodiments, as shown in Fig. 27, it can be observed that using common random subinterleavers instead of independent random subinterleavers, results in a significant degradation in the error floor region.

Embodiments of the present invention provide an improved performance for zigzag codes. Worst-case patterns for zigzag codes are avoided by embodiments of the present invention as well as common mappings of different interleavers, which result in the benefits shown above. Furthermore, embodiments of the present invention can be implemented with a lower complexity compared with the state of the art concepts as, for example, convolutional codes and turbo codes.

Depending on certain implementation requirements of the inventive methods, the inventive method can be implemented in hardware or in software. The implementation can be performed using a digital storage medium, in particular, a disc, DVD or a CD having an electronically-readable control signal stored thereon, which cooperate with a programmable computer system such that the inventive methods are performed. Generally, the present invention is, therefore, a computer program product with a program code stored on a machine-readable carrier, the program code being operative for performing the inventive methods when the computer program product runs on a computer. In other words, the inventive methods are, therefore, a computer program having a program code for performing at least one of the inventive methods when the computer program runs on a computer.

Reference List

100    Encoder
110    Segmenter
120    Zigzag encoder core
130    Interleaver

140     Output codeword constructor

300     Decoder
310     Segmenter
320     Interleaver
330     Zigzag decoder

22a     Cyclic random interleaver with one cyclic shift
22b     Cyclic UMTS interleaver with one cyclic shift
22c     Random interleaver
22d     Congruential interleaver
22e     s-random congruential interleaver
22f     Zigzag random interleaver
22g     AB random interleaver
22h     Cyclic UMTS interleaver with three cyclic shifts
22i     Cyclic random interleaver with three cyclic shift

23a     Random interleaver
23b     Cyclic random interleaver with three cyclic shifts
23c     Cyclic UMTS interleaver with three cyclic shifts
23d     Congruential interleaver
23e     s-random congruential interleaver
23f     Zigzag random interleaver with common mappings
23g     AB random interleaver

**Claims**

1.  Encoder (100) for generating an output codeword based on an input information word, the input information word having fewer bits than the output word, comprising:

    a segmenter (110) for segmenting the input information word into a plurality of ordered segments, the segments having bits;
    a zigzag encoder (120) for calculating a redundancy bit for a current segment, wherein a redundancy bit of an earlier segment in the order is used when calculating the redundancy bit for the current segment;
    an interleaver (130) for interleaving the bits of the plurality of segments using an interleaving rule to obtain an interleaved version;
    an output codeword constructor (140) for constructing the output codeword using the input codeword or the interleaved version thereof and a set of redundancy bits generated by the zigzag encoder (120) fed by the interleaved version;

    wherein the interleaver (130) is adapted to use the interleaving rule being such that for at least 50% of all segments of the input information word bits of the input information word within the same segment are relocated to at least one different segment of the interleaved version.

2.  Encoder (100) of claim 1, wherein the output codeword constructor (140) is adapted for constructing the output codeword further using redundancy bits generated by the zigzag encoder core (120) fed by the input codeword or wherein the interleaver (130) is adapted for obtaining a further interleaved version of the information bits of the plurality of segments using a further interleaving rule and the output codeword constructor (140) being adapted for constructing the output codeword further using redundancy bits generated by the zigzag encoder core (120) fed by the further interleaved version.

3.  Encoder (100) of one of the claims 1 or 2, wherein the interleaver (130) is adapted for using an interleaving rule being such that two bits being located in the same segment of the input information word are relocated to separate segments in the interleaved version.

4.  Encoder (100) of one of the claims 1 to 3, wherein the interleaver (130) is adapted for using an interleaving rule being such that for two bits being located in adjacent segments of the input codeword are separated by at least two segments in the interleaved version.

**5.** Encoder (100) of one of the claims 1 to 4, wherein the interleaver (130) is adapted for using an interleaving rule, being such that two output codewords being constructed using two interleaved versions of two input information words and two sets of redundancy bits generated by the zigzag encoder core (120) fed by the two interleaved versions, and having a higher Hamming weight than the input information words.

**6.** Encoder (100) of claim 5, wherein an output codeword has a Hamming weight being larger than 2.

**7.** Encoder (100) of one of the claims 1 to 6, wherein the interleaver (130) is adapted for using an interleaving rule comprising a sub-step of randomly assigning to a position of a bit in the input information word a position in the interleaved version.

**8.** Encoder (100) of one of the claims 1 to 7, wherein the interleaver (130) is adapted for using an interleaving rule comprising a sub-step of randomly assigning to a position of a bit in the input information word a position from an allowed region in the interleaved version, the allowed region having a certain distance to positions of bits that have been previously assigned.

**9.** Encoder (100) of claim 8, wherein the allowed region is determined from all positions in the interleaved version but blocked regions being positioned having been assigned previously or establishing a certain distance to previously assigned positions from a certain segment.

**10.** Encoder (100) of claim 9, wherein the interleaver (130) is adapted for providing at least two interleaved versions based on the interleaving rule and a further interleaving rule, the first interleaving rule being such that at least a position of 10% of the bits from the input information word get assigned to positions in the further interleaved version, which are different from the positions they are assigned to in the interleaved version.

**11.** Encoder (100) of one of the claims 1 to 10, wherein the interleaver (130) is adapted for obtaining the further interleaved version by interleaving the interleaved version.

**12.** Encoder (100) of one of the claims 1 to 11, wherein the interleaver (130) is adapted for using an interleaving rule based on assigning random positions within predefined regions from the interleaved version to positions of the input information word.

**13.** Encoder (100) of claim 12, wherein the interleaver (130) is adapted for further interleaving the predefined regions.

**14.** A method for generating an output codeword based on an input information word, the input information word having less bits than the output codeword, comprising the steps of:

segmenting the input information word into a plurality of ordered segments, the segments having bits;
calculating a redundancy bit for a current segment, wherein a redundancy bit of an earlier segment in the order is used when calculating the redundancy bit for the current segment;
interleaving the bits of the plurality of segments using an interleaving rule to obtain an interleaved version;
constructing the output codeword using the input codeword or the interleaved version thereof and set of redundancy bits calculated from the interleaved version;
wherein the interleaving uses the interleaving rule, being such that at least 50% of all segments of the input information word bits of the input information word within the same segment are relocated to at least one different segment of the interleaved version.

**15.** Computer program with a program code for performing the method according to claim 14, when the program code runs on a computer.

**16.** Decoder (300) for decoding an input codeword and for generating an output information word, the output information word having less bits than the input codeword, comprising:

a segmenter (310) for segmenting the input codeword into a plurality of ordered segments, a segment having information bits and redundancy bits;
an interleaver (320) for interleaving the information bits of the plurality of segments using an interleaving rule to obtain a first interleaved version of the information bits where the interleaver is adapted to use the interleaving rule, being such that at least 50% of all segments of the input information word bits of the information word within the same segment are relocated to at least one different segment of the interleaved version; and
a zigzag decoder (330) for calculating the output information word based on the information bits, the interleaved version of the information bits and the redundancy bits.

17. Method for decoding an input codeword and for generating an output information word, the output information word having fewer bits than the input codeword, comprising the steps of:

segmenting the input codeword into a plurality of ordered segments, the segments having information bits and redundancy bits;
interleaving the information bits of the plurality of segments using an interleaving rule to obtain an interleaved version of the information bits, wherein the interleaving is adapted for using the interleaving rule being such that at least 50% of all segments of the input information word bits of the input information word within the same segment are relocated to at least one different segment of the interleaved version; and
calculating the output information word based on the information bits, the interleaved version of the information bits and the redundancy bits.

18. Computer program with a program code for performing a method according to claim 17, when the program code runs of a computer.

**Amended claims in accordance with Rule 137(2) EPC.**

**1.** Encoder (100) for generating an output codeword based on an input information word, the input information word having fewer bits than the output word, comprising:

a segmenter (110) for segmenting the input information word into a plurality of ordered segments, the segments having bits;
a zigzag encoder (120) for calculating a redundancy bit for a current segment, wherein a redundancy bit of an earlier segment in the order is used when calculating the redundancy bit for the current segment;
an interleaver (130) for interleaving the bits of the plurality of segments using an interleaving rule to obtain an interleaved version;
an output codeword constructor (140) for constructing the output codeword using the input codeword or the interleaved version thereof and a set of redundancy bits generated by the zigzag encoder (120) fed by the interleaved version;

wherein the interleaver (130) is adapted to use the interleaving rule being such that for at least 50% of all segments of the input information word bits of the input information word within the same segment are relocated to at least one different segment of the interleaved version, wherein the interleaving rule is further based on assigning random positions within predefined regions from the interleaved version to positions of the input information word and for further interleaving the predefined regions.

**2.** Encoder (100) of claim 1, wherein the output codeword constructor (140) is adapted for constructing the output codeword further using redundancy bits generated by the zigzag encoder (120) fed by the input codeword or wherein the interleaver (130) is adapted for obtaining a further interleaved version of the information bits of the plurality of segments using a further interleaving rule and the output codeword constructor (140) being adapted for constructing the output codeword further using redundancy bits generated by the zigzag encoder (120) fed by the further interleaved version.

**3.** Encoder (100) of one of the claims 1 or 2, wherein the interleaver (130) is adapted for using the interleaving rule being such that two bits being located in the same segment of the input information word are relocated to separate segments in the interleaved version.

**4.** Encoder (100) of one of the claims 1 to 3, wherein the interleaver (130) is adapted for using the interleaving rule being such that two bits being located in adjacent segments of the input codeword are separated by at least two segments in the interleaved version.

**5.** Encoder (100) of one of the claims 1 to 4, wherein the interleaver (130) is adapted for using the interleaving rule, being such that two output codewords being constructed using two interleaved versions of two input information words and two sets of redundancy bits generated by the zigzag encoder (120) fed by the two interleaved versions, and having a higher Hamming weight than the input information words.

**6.** Encoder (100) of claim 5, wherein an output codeword has a Hamming weight being larger than 2.

**7.** Encoder (100) of one of the claims 1 to 6, wherein the interleaver (130) is adapted for using the interleaving rule comprising the sub-step of assigning the position of a bit in the input information word the random position from the predefined region in the interleaved version, the predefined region having a certain distance to positions of bits that have been previously assigned.

**8.** Encoder (100) of claim 7, wherein the predefined region is determined from all positions in the interleaved version but blocked regions being positioned having been assigned previously or establishing a certain distance to previously assigned positions from a certain segment.

**9.** Encoder (100) of one of the claims 2 to 8, wherein the interleaver (130) is adapted for providing at least two interleaved versions based on the interleaving rule and the further interleaving rule, the first interleaving rule being such that at least a position of 10% of the bits from the input information word get assigned to positions in the further interleaved version, which are different from the positions they are assigned to in the interleaved version.

**10.** Encoder (100) of one of the claims 2 to 9, wherein the interleaver (130) is adapted for obtaining the further interleaved version by interleaving the interleaved version.

**11.** A method for generating an output codeword based on an input information word, the input information word having less bits than the output codeword, comprising the steps of:

> segmenting the input information word into a plurality of ordered segments, the segments having bits;
> calculating a redundancy bit for a current segment, wherein a redundancy bit of an earlier segment in the order is used when calculating the redundancy bit for the current segment;
> interleaving the bits of the plurality of segments using an interleaving rule to obtain an interleaved version;
> constructing the output codeword using the input codeword or the interleaved version thereof and a set of redundancy bits calculated from the interleaved version;

wherein the interleaving uses the interleaving rule, being such that at least 50% of all segments of the input information word bits of the input information word within the same segment are relocated to at least one different segment of the interleaved version, wherein the interleaving rule is further based on assigning random positions within predefined regions from the interleaved version to positions of the input information word and for further interleaving the predefined regions.

**12.** Computer program with a program code for performing the method according to claim 14, when the program code runs on a computer.

**13.** Decoder (300) for decoding an input codeword and for generating an output information word, the output information word having less bits than the input codeword, comprising:

> a segmenter (310) for segmenting the input codeword into a plurality of ordered segments, a segment having information bits and redundancy bits;
> an interleaver (320) for interleaving the information bits of the plurality of segments using an interleaving rule to obtain a first interleaved version of the information bits where the interleaver is adapted to use the interleaving rule, being such that at least 50% of all segments of the input information word bits of the information word within the same segment are relocated to at least one different segment of the interleaved version; and
> a zigzag decoder (330) for calculating the output information word based on the information bits, the interleaved version of the information bits and the redundancy bits, wherein the interleaving rule is further based on assigning random positions within predefined regions from the interleaved version to positions of the input information word and for further interleaving the predefined regions.

**14.** Method for decoding an input codeword and for generating an output information word, the output information word having fewer bits than the input codeword, comprising the steps of:

segmenting the input codeword into a plurality of ordered segments, the segments having information bits and redundancy bits;

interleaving the information bits of the plurality of segments using an interleaving rule to obtain an interleaved version of the information bits, wherein the interleaving is adapted for using the interleaving rule being such that at least 50% of all segments of the input information word bits of the input information word within the same segment are relocated to at least one different segment of the interleaved version; and

calculating the output information word based on the information bits, the interleaved version of the information bits and the redundancy bits, wherein the interleaving rule is further based on assigning random positions within predefined regions from the interleaved version to positions of the input information word and for further interleaving the predefined regions.

**15.** Computer program with a program code for performing a method according to claim 14, when the program code runs of a computer.

## FIG 1

## FIG 2

# FIG 3

# FIG 4

$$0 \oplus 0 \oplus 0 \oplus 0 = 0$$

$$0 \oplus 1 \oplus 1 \oplus 0 = 0$$

$$0 \oplus 0 \oplus 0 \oplus 0 = 0$$

$$w_H = d_{min} = 2$$

constituent code 1

$$\Pi$$

$$0 \oplus 1 \oplus 0 \oplus 0 = 1$$

$$0 \oplus 0 \oplus 0 \oplus 0 = 1$$

$$1 \oplus 0 \oplus 0 \oplus 0 = 0$$

$$w_H > d_{min} = 2$$

constituent code 2

## FIG 5

$0 \oplus 1 \oplus 0 \oplus 0 = 1$

$\oplus$

$0 \oplus 0 \oplus 1 \oplus 0 = 0$

$\oplus$

$0$

$\oplus$

$0 \oplus 0 \oplus 0 \oplus 0 = 0$

$w_H = 3$

constituent code 1

$\Pi \longrightarrow$

$0 \oplus 1 \oplus 0 \oplus 0 = 1$

$\oplus$

$0 \oplus 0 \oplus 0 \oplus 0 = 1$

$\oplus$

$1$

$\oplus$

$1 \oplus 0 \oplus 0 \oplus 0 = 0$

$w_H > 3$

constituent code 2

## FIG 6

$0 \oplus 1 \oplus 0 \oplus 0 = 1$

$\oplus$

$0 \oplus 0 \oplus 1 \oplus 0 = 0$

$\oplus$

$0$

$\oplus$

$0 \oplus 0 \oplus 0 \oplus 0 = 0$

$w_H = 3$

constituent code 1

$\Pi \longrightarrow$

$0 \oplus 0 \oplus 0 \oplus 0 = 0$

$\oplus$

$0 \oplus 0 \oplus 0 \oplus 0 = 0$

$\oplus$

$0$

$\oplus$

$1 \oplus 0 \oplus 1 \oplus 0 = 0$

$w_H = d_{min} = 2$

constituent code 2

## FIG 7

$0 \oplus 1 \oplus 0 \oplus 0 = 1$

$0 \oplus 0 \oplus 1 \oplus 0 = 0$

$0$

$1 \oplus 0 \oplus 1 \oplus 0 = 0$

$w_H = 5$

constituent code 1

$\Pi \longrightarrow$

$0 \oplus 0 \oplus 0 \oplus 0 = 0$

$0 \oplus 0 \oplus 0 \oplus 0 = 0$

$0$

$1 \oplus 1 \oplus 1 \oplus 1 = 0$

$w_H > 4$

constituent code 2

## FIG 8

## FIG 9

blocked area

## FIG 10

blocked by $\Pi_1 - \Pi_{k-1}$

blocked by $\Pi_k$

## FIG 11

## FIG 12

out

in

## FIG 13

out

in

## FIG 14

out

500
400
300
200
100
0

0  100  200  300  400  500

in

## FIG 15

out

500
400
300
200
100
0

0  100  200  300  400  500

in

FIG 16

FIG 17

**FIG 18**

**FIG 19a**

**FIG 19b**

FIG 20a

FIG 20b

FIG 21a

FIG 21b

## FIG 22

## FIG 23

## FIG 24

## FIG 25

## FIG 26

## FIG 27

# FIG 28
(State of the art)

$$d_{1,1} \oplus d_{1,2} \oplus \ldots \oplus d_{1,J} = p_1$$

$$\oplus$$

$$d_{2,1} \oplus d_{2,2} \oplus \ldots \oplus d_{2,J} = p_2$$

$$\oplus$$

$$\vdots$$

$$\oplus$$

$$d_{I-1,1} \oplus d_{I-1,2} \oplus \ldots \oplus d_{I-1,J} = p_{I-1}$$

$$\oplus$$

$$d_{I,1} \oplus d_{I,2} \oplus \ldots \oplus d_{I,J} = p_I$$

# FIG 29
(State of the art)

$d_{i,j}$ ———————→ $d_{i,j}$

$Z^{-1}$ ← $0, \ldots, 0, 1$ ⊗→ $p_i$

# FIG 30
(State of the art)

$$0 \oplus 0 \oplus 0 \oplus 0 = 0$$

$$\oplus$$

$$0 \oplus 1 \oplus 1 \oplus 0 = 0$$

$$\oplus$$

$$\vdots$$

$$0$$

$$\oplus$$

$$0 \oplus 0 \oplus 0 \oplus 0 = 0$$

$$w_H = d_{min} = 2$$

# FIG 31
(State of the art)

$$0 \oplus 1 \oplus 0 \oplus 0 = 1$$

$$\oplus$$

$$0 \oplus 0 \oplus 1 \oplus 0 = 0$$

$$\oplus$$

$$\vdots$$

$$0$$

$$\oplus$$

$$0 \oplus 0 \oplus 0 \oplus 0 = 0$$

$$w_H = 3$$

# FIG 32
(State of the art)

$d_{i,j}$

$d_{i,j}$

code *1* $\rightarrow p_{1,i}$

$\cdots$

$\Pi_1$ code *2* $\rightarrow p_{2,i}$

$\Pi_{K-1}$ code *K* $\rightarrow p_{K,i}$

# FIG 33
(State of the art)

BER

good randomization

avoid worst case patterns

SNR

# FIG 34
(State of the art)

Decoder 1 $\quad L_{e,1}$ Decoder 2 $\quad L_{e,2}$ Decoder K $\quad L_{e,k}$

$L_c$

$L_{app}$

# FIG 35
(State of the art)

$\Pi \longrightarrow \Delta_{k,1} \cdots \longrightarrow \Pi \longrightarrow \Delta_{k,D}$

$\Pi_k$

**European Patent Office**

# EUROPEAN SEARCH REPORT

Application Number

EP 06 02 4549

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | XIAOLING HUANG: "Turbo Codes and Zigzag Codes: Performance Analysis and Simulation" [Online] December 2000 (2000-12), DISSERTATION, THE GRADUATE SCHOOL, STATE UNIVERSITY OF NEW YORK , STONY BROOK, USA , XP002419490 Retrieved from the Internet: URL:http://www.ece.sunysb.edu/~phamdo/xhuang.pdf> [retrieved on 2007-02-12] | 1-12, 14-18 | INV. H03M13/27 ADD. H03M13/29 |
| A | * page 69 - page 126 *<br>----- | 13 | |
| Y | EP 1 441 448 A2 (NOKIA CORP [FI]) 28 July 2004 (2004-07-28) * paragraphs [0021] - [0026] * * figures 3A,3C,4 *<br>----- | 1,14-18 | |
| Y | LI PING ET AL: "Iterative decoding of multi-dimensional concatenated single parity check codes" PROC IEEE INTERNATIONAL CONFERENCE ON COMMUNICATIONS, vol. 1, 7 June 1998 (1998-06-07), pages 131-135, XP010284548 Atlanta, USA ISBN: 0-7803-4788-9 * page 132 * * page 134 * * figure 1 *<br>-----<br>-/-- | 1,14-18 | TECHNICAL FIELDS SEARCHED (IPC)<br><br>H03M |

The present search report has been drawn up for all claims

| Place of search | Date of completion of the search | Examiner |
|---|---|---|
| Munich | 14 February 2007 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                            

& : member of the same patent family, corresponding document

EPO FORM 1503 03.82 (P04C01)

**European Patent Office**

**EUROPEAN SEARCH REPORT**

Application Number

EP 06 02 4549

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TEE J S K ET AL: "Multiple parallel concatenated single parity check codes" PROC. IEEE INTERNATIONAL CONFERENCE ON COMMUNICATIONS 2001, vol. VOL. 1 OF 10, 11 June 2001 (2001-06-11), pages 60-64, XP010552966 Helsinki, Finnland ISBN: 0-7803-7097-1 * page 60, right-hand column * * page 61, right-hand column - page 62, left-hand column * * figures 1,4 * | 1-18 | |
| A | CHAN K S ET AL: "A DATA LINK CONTROL PROTOCOL FOR WIRELESS ATM NETWORKS WITH ADAPTIVE CODING RATE" PROCEEDINGS OF THE IEEE CONFERENCE 2000 ON HIGH PERFORMANCE SWITCHING AND ROUTING, 26 June 2000 (2000-06-26), pages 483-489, XP001075738 Heidelberg, Germany ISBN: 0-7803-5884-8 * page 484, right-hand column - page 485, left-hand column * * figures 1,2 * | 1-18 | TECHNICAL FIELDS SEARCHED (IPC) |

The present search report has been drawn up for all claims

| Place of search | Date of completion of the search | Examiner |
|---|---|---|
| Munich | 14 February 2007 | Burkert, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 02 4549

This annex lists the patent family members relating to the patent documents cited in the above-mentioned European search report.
The members are as contained in the European Patent Office EDP file on
The European Patent Office is in no way liable for these particulars which are merely given for the purpose of information.

14-02-2007

| Patent document cited in search report | | Publication date | Patent family member(s) | Publication date |
|---|---|---|---|---|
| EP 1441448 | A2 | 28-07-2004 | US 2004123215 A1 | 24-06-2004 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **L. PING ; X. HUANG ; N. PHAMDO.** Zigzag codes and concatenated zigzag codes. *IEEE Transactions on Information Theory,* February 2001, vol. 47, 800-807
- **S.-N. HONG ; D.-J. SHIN.** Construction and analysis of rate compatible punctured concatenated zigzag codes. *International Symposium on Information Theory (ISIT),* September 2005, 840-844
- Optimal rate-compatible punctured concatenated zigzag codes. **S.-N. HONG ; D.-J. SHIN.** International Conference on Communications (ICC). IEEE, May 2005, 627-631
- Design of irregular concatenated zigzag codes. **S.-N. HONG ; D.-J. SHIN.** International Symposium on Information Theory (ISIT). IEEE, September 2005, 1363-1366
- Iterative decoding of multidimensional concatenated single parity check codes. **L. PING ; S. CHAN ; K. YEUNG.** International Conference on Communications (ICC). IEEE, June 1998, 131-135
- On concatenated zigzag codes and their decoding schemes. **X. WU ; Y. XUE ; H. XIANG.** IEEE Communications Letters. January 2004, vol. 8, 54-56
- Multi-dimensional zigzag codes for high data rate transmission. **N. NEFEDOV.** 3rd International Symposium on Turbo Codes and Related Topics. September 2003, 215-218
- **N. NEFEDOV.** 14th International Symposium on Personal, Indoor and Mobile Radio Communications. September 2003, 1868-1872
- **L. BAHL ; J. COCKE ; F. JELINEK ; J. RAVIV.** Optimal decoding of linear codes for minimizing symbol error rate. *IEEE Transactions on Information Theory,* March 1974, vol. IT-20, 284-287
- **J. HAGENAUER ; E. OFFER ; L. PAPKE.** Iterative decoding of binary block and convolutional codes. *IEEE Transactions on Information Theory,* March 1996, vol. IT-42, 425-429
- **N. NEFEDOV.** Multi-dimensional zigzag codes for high data rate transmission. *3rd International Symposium on Turbo Codes and Related Topics,* September 2003, 215-218
- **N. NEFEDOV.** Evaluation of low complexity concatenated codes for high data rate transmission. *14th International Symposium on Personal, Indoor and Mobile Radio Communications,* September 2003, 1868-1872

- **A. TARABLE ; G. MONTORSI ; S. BENEDETTO.** Analysis and design of interleavers for iterative multi-user receivers in coded CDMA systems. *IEEE Transactions on Information Theory,* May 2005, vol. 51, 1650-1666
- **S. BRÜCK ; U. SORGER ; S. GLIGOREVIC ; N. STOLTE.** Interleaving for outer convolutional codes in DS-CDMA systems. *IEEE Transactions on Communications,* July 2000, vol. 48, 1100-1107
- Cyclically shifted multiple interleavers. **K. KUSUME ; G. BAUCH.** Globecom. IEEE, December 2006
- **KUSUME ; G. BAUCH.** Some aspects of interleave division multiple access in ad hoc networks. *4th International Symposium on Turbo Codes and Related Topics,* April 2006
- **A. BARBULESCU ; S. PIETROBON.** Interleaver design for three dimensional turbo codes. *IEEE International Symposium on Information Theory,* September 1995, 37
- **N. EHTIATI ; M. SOLEYMANI ; H. SADJADPOUR.** Interleaver design for multiple turbo codes. *Canadian Conference on Electrical and Computer Engineering,* May 2003, 1605-1607
- **N. EHTIATI ; M. SOLEYMANI ; H. SADJADPOUR.** Joint interleaver design for multiple turbo codes. *IEEE Vehicular Technology Conference (VTC Fall),* September 2004, 2302-2306
- **A. TARABLE ; G. MONTORSI ; S. BENEDETTO.** Analysis and design of interleavers for iterative multiuser receivers in coded. CDMA systems. *IEEE Transactions on Information Theory,* May 2005, vol. 51, 1650-1666
- **K. KUSUME ; G. BAUCH.** Some aspects of interleave division multiple access in ad hoc networks. *4th International Symposium on Turbo Codes and Related Topics,* April 2006
- **N. EHTIATI ; M. SOLEYMANI ; H. SADJADPOUR.** Joint interleaver design for multiple turbo codes. *IEEE Vehicular Technology Conference (VTC Fall,* September 2004, 2302-2306
- **A. BARBULESCU ; S. PIETROBON.** Interleaver design for three dimensional turbo codes. *IEEE International Symposium on Information Theory,* September 1995

- **S. CROZIER ; J. LODGE ; P. GUINAND ; A. HUNT.** Performance of turbo-codes with relative prime and golden interleaving strategies. *International Mobile Satellite Conference,* 1999, 268-275